**Europäisches Patentamt**

**European Patent Office**

**Office européen des brevets**

(11) Numéro de publication: **0 005 183**
**B1**

(12) **FASCICULE DE BREVET EUROPEEN**

(45) Date de publication du fascicule de brevet: **04.11.81**

(21) Numéro de dépôt: **79101057.2**

(22) Date de dépôt: **06.04.79**

(51) Int. Cl.³: **H 01 L 29/82,**
**H 01 L 29/10, G 01 R 33/02**

(54) Détecteur de champs notamment magnétiques du type transistor à effet de champ à semi-conducteur.

(30) Priorité: **03.05.78 US 902327**

(43) Date de publication de la demande:
**14.11.79 Bulletin 79/23**

(45) Mention de la délivrance du brevet:
**04.11.81 Bulletin 81/44**

(84) Etats Contractants Désignés:
**DE FR GB**

(56) Documents cités:
**DE - A - 2 044 792**
**FR - A - 1 440 443**
**FR - A - 2 239 017**
**FR - A - 2 288 397**
**FR - A - 2 350 694**
**US - A - 3 702 991**

**MEASUREMENT AND CONTROL, Vol. 6,**
**janvier 1973**
**LONDON (GB)**
**J. E. L. HOLLIS: "Micro-electronic magnetic**
**transducers", pages 38—40**

(73) Titulaire: **International Business Machines Corporation**
**Armonk, N.Y. 10504 (US)**

(72) Inventeur: **Vinal, Albert Watson**
**810 Queensferry Rd.**
**Cary, NC 27511 (US)**

(74) Mandataire: **Klein, Daniel**
**COMPAGNIE IBM FRANCE Département de Propriété Industrielle**
**F-06610 La Gaude (FR)**

Courier Press, Leamington Spa, England.

## O 005 183

### Détecteur de champs notamment magnétiques du type transistor
### à effet de champ à semi-conducteur

### Domaine technique
La présente invention concerne les détecteurs de champs en général et, plus particulièrement, les détecteurs de champs magnétiques à semi-conducteurs du type à transistor à effet de champ.

### Etat de la Technique
Les détecteurs magnétiques à transistor à effet de champ (FET) de l'art antérieur font appel à l'emploi de l'effet de Lorentz en vertu duquel les porteurs qui circulent entre une source et un ou plusieurs drains d'un transistor FET font l'objet d'une déviation. Cet effet permet de créer un déséquilibre entre les courants de drain du transistor de manière à obtenir une sortie différentielle. A cet égard, on se reportera, par exemple, à la publication intitulée "IBM Technical Disclosure Bulletin", Vol. 13, No. 12, mai 1971, page 3633, ou au brevet britannique No. 1 243 178 qui décrit un détecteur magnétique comportant un transistor FET dont le canal est pourvu à ses extrémités opposées d'une source et de deux ou trois drains. Ainsi que le comprendra l'homme de l'art, une couche conductrice convenable faisant fonction d'électrode de porte et une couche d'oxyde servant d'isolant sont également formées dans de tels dispositifs afin de commander la circulation du courant dans le canal.

Dans le brevet britannique précité, l'application d'une tension appropriée à la porte permet d'établir une couche d'inversion servant de canal conducteur. Ce dernier s'étend entre la source et deux ou trois drains. La source est reliée à la masse et les drains sont reliés à une tension d'alimentation par l'intermédiaire de charges résistives qui peuvent être de même valeur. On sait que, lorsque des tensions convenables sont appliquées à la source, au(x) drain(s) et à la porte, un courant circule entre la source et le ou les drains. On a pensé que ce courant pouvait faire l'objet d'une déviation (ou déflexion) par suite de l'effet Lorentz résultant de la présence d'un champ magnétique dans la trajectoire des porteurs de charges et que cela provoquait une accumulation des charges sur un côté du canal et un appauvrissement des charges sur le côté opposé jusqu'à ce que le champ électrique créé par le déplacement des charges ait appliqué aux porteurs de charge une force égale à celle résultant du champ magnétique et opposée à celle-ci.

Ce phénomène classique en vertu duquel une accumulation des charges se produirait dans le canal pour contrebalancer la déviation des porteurs de charge, se traduit par l'emploi de canaux relativement larges, dans les dispositifs à transistors FET, afin que les porteurs de charge puissent faire l'objet d'une déviation sans qu'il en résulte pour autant une interaction (ou une "accumulation des charges") importante. Il est évident qu'un canal large permet la circulation de courants relativement plus importants qu'un canal étroit. Dans le mode différentiel, un petit nombre seulement de porteurs de charge (ceux qui se trouvent à proximité du centre du canal) sont effectivement déviés de manière à frapper un drain particulier plutôt qu'un autre. La majorité des porteurs qui se trouvent dans un canal large s'ajoute par conséquent au courant obtenu aux drains sans subir l'effet Lorentz. De ce fait, les tensions de bruit produites dans les résistances de charge sont plus importantes que dans le cas d'un dispositif à canal étroit. D'autre part, étant donné qu'un petit nombre seulement de porteurs peut faire l'objet d'une déviation de manière à produire un signal, les niveaux des signaux obtenus risquent d'être relativement plus faibles qu'on pourrait le désirer par rapport aux niveaux de bruit. Par ailleurs, du fait de la largeur relativement plus grande que présente un canal de ce type, la résolution du dispositif, c'est-à-dire la bande la plus étroite du flux magnétique qui peut être utilisée pour dévier les porteurs qui produisent un signal de sortie, sera moins grande.

Le fait qu'on utilise des canaux larges, c'est-à-dire des canaux dont la largeur est supérieure à celle de la plus petite source ou du plus petit drain, indique qu'on n'a pas tenu compte dans l'art antérieur de la largeur des régions d'appauvrissement qui se trouvent le long des côtés du canal. En effet, ces régions constituent une partie insignifiante de la largeur du canal dans de tels dispositifs. Au contraire, dans la présente invention, on montrera que la largeur des régions d'appauvrissement du canal constitue une partie importante de la largeur totale de celui-ci parce que le canal a une si faible largeur que les régions d'appauvrissement occupent une partie relativement plus importante de sa largeur totale.

Des agencements classiques d'un type légèrement différent utilisent des dispositifs à jonction dans lesquels la source et le ou les drains se composent de régions formées dans un substrat semi-conducteur d'un type de conductivité opposé. De tels dispositifs sont décrits, par exemple, dans les brevets des E.U.A. Nos. 3 167 663, 3 714 559, 3 731 123 et 3 829 883. L'un des problèmes qui se posent dans le cas de détecteurs de champs magnétiques du type à transistor FET réside dans la difficulté d'obtenir une sensibilité élevée, des signaux de sortie d'amplitude suffisamment grande et des rapports signal/bruit acceptables tout en travaillant dans des largeurs de bande suffisantes.

Dans les brevets précités No. 3 714 559 et 3 829 883, on a décrit un détecteur de champs magnétiques à transisto: FET à drains multiples dans lequel la porte est polarisée à une valeur inférieure au seuil du transistor, le premier drain est polarisé de façon à produire un claquage par avalanche de la jonction avec le substrat, le second et le troisième drains étant polarisés à une tension inférieure à celle qui est nécessaire pour obtenir le claquage par avalanche de leurs jonctions. Dans ce mode de

**0 005 183**

fonctionnement, le canal du transistor FET n'est pas effectivement rendu conducteur, si bien qu'il n'y a pas lieu d'employer des transistors FET dans ce type de dispositif puisqu'aucun "canal" n'existe. Dans ces mêmes brevets et selon un autre mode de réalisation, l'un au moins des drains est du même type de conductivité que le substrat, mais est plus fortement dopé. Ce dernier dispositif permet d'obtenir un courant entre la diffusion de source et la jonction, et fonctionne, semble-t-il, davantage comme une diode. Ces dispositifs présentent une sensibilité élevée, des signaux de sortie d'amplitude relativement grande et de bons rapports signal/bruit, mais ne sont pas utilisés en tant que transistors FET. Leur action s'exerce, semble-t-il, en accélérant les trous qui ont été déviés par un champ magnétique, et ces porteurs minoritaires présentaraient une plus grande sensibilité. Les difficultés que présentent le contrôle des ruptures (claquages) par avalanche et la génération de paires trou-électron en nombre suffisant pour permettre la circulation d'un courant de trous entre la source et le drain, peuvent se révéler insurmontables dans certaines applications. Il semblerait préférable d'utiliser, si possible, un courant de porteurs majoritaires dans des dispositifs utilisés en tant que transistors FET.

Les brevets précités No. 3 167 663 et 3 731 123 décrivent d'autres détecteurs de champ magnétique du type à jonction P—N (bipolaire) fonctionnement essentiellement comme des diodes, dans lesquels la circulation du courant peut être modifiée ou dirigée au moyen de champs magnétiques externes. Ces dispositifs fonctionneraient dans la région de circulation d'un courant important dans laquelle les porteurs injectés sont déviés par l'effet Lorentz de telle sorte que l'on obtienne un déplacement latéral des porteurs et un signal de sortie différentiel entre deux drains (ou davantage) à jonction PN. Ces dispositifs possédent des courants intrinsèques plus élevés et, bien qu'ils puissent être sensibles aux champs magnétiques, présentent une sensibilité plus grande aux courants de bruit.

Le brevet de E.U.A. No. 3 593 045 décrit un dispositif de type analogue dans lequel un faisceau d'électrons créé dans un dispositif semi-conducteur, est dévié vers une ou plusieurs cibles par des champs électriques ou magnétiques. Ce dispositif n'est pas employé en tant que transistor FET et exige, comme il est dit dans ce brevet, des tensions de commande de polarisation relativement élevées, de l'ordre de 200 volts, ce qui s'oppose à son utilisation dans des circuits intégrés à effet de champ.

Il existe par ailleurs des dispositifs à effet Hall (décrits notamment dans le brevet des E.U.A. No. 3 448 353) qui n'utilisent pas directement la déviation des porteurs, mais qui tirent parti de la tension résiduelle ou de décalage due à la déflexion, créée par l'effet Lorentz, de lignes équipotentielles de porteurs transversalement aux connexions d'entrée et de sortie. Les dispositifs à effet Hall présentent en général de faibles rapports longueur/largeur (inférieurs à 3 environ) et fonctionnent dans des conditions optimum lorsque leur longueur est égale à leur largeur. On sait également que, dans ces dispositifs, le signal de sortie est proportionnel à la vitesse des porteurs et non au nombre de ceux-ci. Etant donné qu'il ne s'agit pas en l'occurrence de dispositifs à transistors FET dont le fonctionnement est tel qu'un faisceau de porteurs soit dévié et qu'un signal de sortie différentiel soit obtenu aux drains, seule une tension de sortie, aux bornes des sondes disposées d'un côté et de l'autre du canal, est utilisable. Il est préférable qu'un courant de signal soit effectivement obtenu à un ou plusieurs drains comme dans le cas du dispositif décrit dans le brevet britannique précité.

Il existe également dans l'art antérieur des dispositifs à charge couplée qui permettent de commander l'état du courant circulant dans le canal relativement large d'un transistor FET (cf. notamment la publication intitulée "IBM Technical Disclosure Bulletin", Vol. 14, No. 11, avril 1972, page 3420, et le brevet des E.U.A. No. 3 714 523). Le dispositif décrit dans ce dernier brevet constitue un détecteur de champs magnétiques extrêmement sensible et utilise à cette fin un contrôle différential des électrodes de porte couplées depuis les drains de manière à obtenir une réaction positive. Les dispositifs à charge couplée permettent également d'obtenir des signaux de sortie amplifiés. Toutefois, compte tenu de la largeur relativement plus importante de ces dispositifs et des courants plus forts qui les traversent, une tension de sortie présentant un bruit plus important risque d'être obtenue et qui serait alors amplifiée par le mécanisme de réaction. La grande largeur de ces dispositifs indique évidemment que les régions d'appauvrissement qui se trouvent de chaque côté du canal consituent une partie insignifiante de la largeur totale de ce dernier.

## Exposé de l'invention

L'un des buts de la présente invention est donc de fournir un détecteur de champs magnétiques extrêmement sensible du type à canal de conduction, présentant des courants de canal relativement faibles et des tensions de bruit très faibles, de manière à obtenir des rapports signal/bruit élevés aux amplitudes de tension de sortie utilisées et à des largeurs de bande de signaux de sortie adéquates.

Un autre but de l'invention est de fournir un détecteur du type à canal de conduction, comportant deux canaux en forme de filament caractérisés par un rapport longueur/largeur relativement élevé et dans lesquels des régions de conduction étroites et limitées pour les porteurs de charge; ces derniers peuvent faire l'objet d'une déviation maximale vers la gauche ou vers la droite au moyen d'un mécanisme de modulation de la largeur des régions d'appauvrissement commandé par une tension de Lorentz engendrée dans un canal de couplage situé entre les deux canaux en forme de filament et qui les relie électriquement.

Un autre but de l'invention est de fournir un détecteur du type à canal de conduction dans lequel

3

existent des régions d'appauvrissement relativement larges qui constituent une partie relativement importante de la largeur totale des canaux en forme de filament.

Ces buts et d'autres sont atteints grâce à l'emploi, (dans le mode d'enrichissement ou dans le mode d'appauvrissement), d'au moins deux canaux de conduction relativement longs, étroits et séparés l'un de l'autre, dont chacun comporte le long de ses côtés des régions d'appauvrissement dont la largeur est relativement importante par rapport à la région non appauvrie du canal. Un tel dispositif est appelé ci-après dispositif de Vinhall à double canal afin de le distinguer d'autres dispositifs à canal de conduction qui seront étudiés plus loin. Les paramètres de longueur et de largeur qui sont utilisés pour définir un dispositif de Vinhall d'une façon générale permettent également de définir la forme des canaux de conduction, qui est celle d'un filament.

De façon plus précise, la présente invention concerne un détecteur de champs du type transistor à effet de champ à semi-conducteur, comportant un substrat en matériau semi-conducteur, une région de source et au moins deux régions de drain distinctes, caractérisé en ce qu'il comprend au moins deux canaux de conduction formés dans le substrat qui connectent chacun la source et un drain, ces canaux ont la forme d'un filament défini par le fait que le rapport de la largeur Vinhall à la largeur du canal à proximité de ladite source est supérieur à 0 et inférieur à 0,98, et un canal de conduction engendrant une tension de Lorentz, disposé dans ledit substrat entre les canaux, couplant électriquement ces derniers, de telle sorte que la tension de Lorentz leur soit appliquée dans une direction perpendiculaire au parcours des porteurs dans les canaux.

La plage résultante de rapports longueur/largeur qui peut être définie correspond à la création de canaux de conduction qui sont plus étroits d'un à deux ordres de grandeur environ ($10^{-1}$ à $10^{-2}$) que ceux de l'art antérieur. Ce facteur mène à une étude du mécanisme en vertu duquel les canaux de conduction de porteurs de charge, canaux dont les limites sont définies par les régions d'appauvrissement, peuvent faire l'objet d'une déviation et des sources de bruit dans de tels détecteurs.

Une telle étude rend possible la réalisation de dispositifs présentant une sensibilité et des rapports signal/bruit beaucoup plus importants que ceux obtenus dans le cas des dispositifs de l'art antérieur. Des rapports signal/bruit de l'ordre de 50 à 1 à plus de 300 à 1 ont effectivement pu être obtenus au moyen de la présente invention avec des champs magnétiques normaux de 350 Gauss.

D'autres objets, caractéristiques et avantages de la présente invention ressortiront mieux de l'exposé qui suit, fait en référence aux dessins annexés à ce texte, qui représentent un mode de réalisation préféré de celle-ci.

Brève description des figures

La figure 1 représente une vue de dessus d'un dispositif à canal de conduction unique du type filament créé dans un substrat en matériau semi-conducteur, de la façon décrite dans la demande de brevet européen No. 78 4300004/8 déposée par la demanderesse le 22 juin 1978 et publiée sous le No. 318.

Les figures 2 à 4 illustrent le mécanisme de modulation de la largeur des régions d'appauvrissement qui définissent un canal unique et montrent la façon dont cette modulation permet de déplacer effectivement les limites de celui-ci dans les dispositifs réalisés conformément à la présente invention.

Les figures 5 et 6 sont respectivement une vue de dessus et une vue en coupe d'un canal du type créé par enrichissement qui peut être utilisé pour mettre en oeuvre la présente invention.

Les figures 7 et 8 sont respectivement une vue de dessus et une vue en coupe d'un rèalisation préférée d'un détecteur Vinhall à deux canaux conforme à la présente invention.

Les figures 9 et 10 sont des vues en coupe détaillées prises suivant la ligne A—A de la figure 7.

La figure 11 est un schéma permettant de calculer le courant de canal nécessaire pour obtenir une conduction dans l'un l'autre des canaux et dans l'un ou l'autre des modes de fonctionnement et de réalisation de la présente invention.

La figure 12 est un graphique représentant les concentrations des porteurs en fonction de la profondeur du canal au-dessous de là surface d'un substrat.

La figure 13 représente le circuit qui permet de faire fonctionner les deux canaux du dispositif de Vinhall à la tension de pincement.

La figure 14 est un graphique représentant le courant de drain en fonction de la tension dans le cas d'un transistor FET et montre les régions de fonctionnement ainsi que leurs points critiques.

Les figures 15 à 17 représentent respectivement la région de charge d'espace, le champ électrique et le potentiel qui existent à la jonction P—N le long de chaque côté des canaux de conduction dans des dispositifs conformes à la presente invention.

La figure 18 représente une coupe longitudinale d'un canal implanté du type utilisé dans la présente invention.

La figure 19 représente une variante de la réalisation de la figure 18.

La figure 20 est un graphique représentant l'amplitude des signaux et les rapports signal/bruit calculés pour un dispositif Vinhall en fonction de la résistivité du substrat.

Les figures 21 et 22 représentent une autre réalisation dans laquelle le canal central de couplage s'élargit à proximité des drains dans un dispositif fonctionnant en mode d'enrichissement.

Les figures 23 et 24 montrent une autre réalisation dans laquelle le canal de couplage ainsi que les deux canaux Vinhall s'élargissent à proximité des drains dans un dispositif fonctionnant en mode d'appauvrissement.

## Description de l'invention

Les principes de fonctionnement des dispositifs de la présente invention et les caractéristiques qui les distinguent des dispositifs de l'art antérieur sont décrits ci-après. Il est cependant nécessaire de formuler quelques remarques préliminaires. Tout d'abord, le dispositif Vinhall de la présente invention possède deux canaux de conduction qui, contrairement aux canaux des dispositifs de l'art antérieur, sont rendus aussi étroits que possible. Les techniques photolithographiques actuelles permettent de réaliser de tels canaux d'une largeur de l'ordre de 2,5 microns (ou $2,54 \times 10^4 Å$). Il pourrait être néanmoins souhaitable de réduire davantage encore cette largeur.

La largeur Vinhall minimum de chaque canal doit être d'au moins quelques centaines d'angströms pour permettre d'obtenir une certaine circulation du courant. Les techniques actuelles ne permettent pas d'obtenir des canaux aussi étroits, mais les canaux les plus étroits qui peuvent effectivement être réalisés fonctionnent de façon satisfaisante. Le fait que les techniques actuelles ne permettent pas d'obtenir des canaux aussi étroits qu'il serait souhaitable ne saurait donc constituer une limitation de la présente invention. Il suffit que la largeur des canaux corresponde à la valeur minimum qui peut actuellement être atteinte ou soit voisine de cette valeur.

Deuxièmement, le dispositif selon l'invention est un type distinct de détecteur à déviation de l'écoulement des porteurs de charge. Son fonctionnement est complètement différent de celui des dispositifs à effet Hall. En effet, le dispositif Vinhall selon l'invention provoque une déviation des limites effectives des régions d'appauvrissement qui canalisent l'écoulement des porteurs de charge et détecte les effets de cette déviation au niveau de deux drains de sortie ou davantage.

Une autre caractéristique du dispositif selon l'invention réside dans le fait que l'on fait varier les limites de l'écoulement des porteurs de charge et donc les courants des différents canaux, en modulant la largeur des régions d'appauvrissement des canaux dans le cas de porteurs animés d'une vitesse constante ou présentant un gradient de vitesse. A l'opposé, un dispositif à effet Hall ne produit aucun courant de sortie et, en fait, aucun courant ne pourrait être obtenu aux bornes de sortie d'un tel dispositif sans nuire gravement à son fonctionnement.

Ainsi qu'on le verra plus loin, la condition d'obtention d'un signal à la sortie d'un dispositif Hall est l'existence d'un gradient de vitesse des porteurs dans son canal de conduction. Aucun signal de quelque importance ne peut être obtenu sans un tel gradient. C'est ce gradient et non le nombre de porteurs que le dispositif Hall utilise. Pour pouvoir fonctionner, un dispositif Hall a besoin dudit gradient afin de faire tourner les lignes équipotentielles qui se trouvent dans le canal de manière à induire une différence de potentiel à la sortie du dispositif. Si l'on cherche à tirer un courant important de la ou des bornes de sortie, on risque de déformer la configuration des lignes équipotentielles et, par conséquent, d'empêcher le dispositif de fonctionner correctement. En revanche, le dispositif Vinhall de la présente invention fonctionne très efficacement sans aucun gradient de vitesse et fait appel au nombre et à la vitesse des porteurs qui se déplacent dans le canal, et à la seule vitesse des porteurs dans le canal de couplage à tension de Lorentz.

Troisièmement, et c'est important, on verra que, le fonctionnement du dispositif de la présente invention à deux canaux Vinhall est fonction de l'épaisseur de chaque canal, de la largeur Vinhall de chaque canal, et de la densité par unité de volume des porteurs de charge qui existent dans le substrat et dans chaque canal de conduction. Cela est en opposition directe avec les enseignements de l'art antérieur selon lesquels il convient d'augmenter et non de diminuer la largeur des canaux afin d'éviter l'accumulation des charges.

*Considérations théoriques*

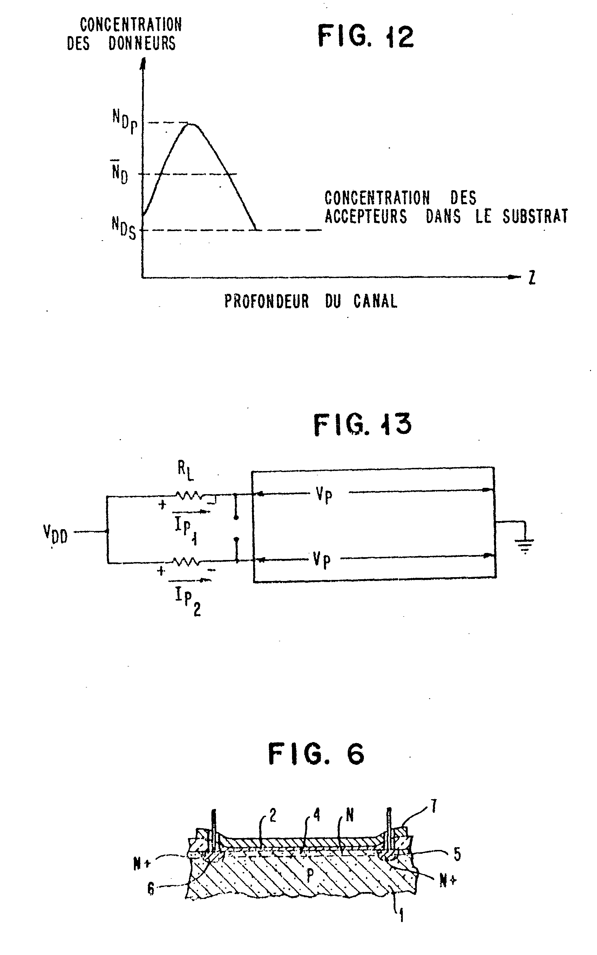

On se reportera à présent à la figure 11 qui représente un bloc de matériau semi-conducteur 1 qui peut être en silicium, en germanium, en arséniure de gallium ou en tout autre matériau ou combinaison de matériaux présentant des propriétés semi-conductrices intrinsèques bien connues. Le bloc 1 comporte un certain nombre de porteurs de charge équidistants répartis le long des axes x, y et z. Comme le montre la figure 11, la largeur W, l'épaisseur T et la longueur L sont respectivement mesurées le long des axes x, z et y. Aucune signification particulière ne s'attache au choix de la notation ici employée aux fins de l'exposé ci-dessous.

Pour analyser un dispositif Vinhall, il est nécessaire d'établir les formules donnant le courant de canal, les fonctions de sortie du détecteur ainsi que les rapports signal/bruit pour un tel dispositif.

On rappellera tout d'abord certains principes physiques nécessaires à la compréhension de l'invention. On désire ici définir la densité des électrons ou des porteurs de charge que comporte le bloc. Sur la figure 11, le bloc 1 représente une faible partie d'un canal semi-conducteur qui est soit implanté, soit induit dans un substrat semi-conducteur au moyen de techniques bien connues. La densité des porteurs de charge sera définie en termes de densité volumique. Soit:

$N_x$ = le nombre de porteurs de charge ou d'ions que comporte le bloc dans la direction x,
$N_y$ = le nombre de porteurs de charge ou d'ions que comporte le bloc dans la direction y, et
$N_z$ = le nombre de porteurs de charge ou d'ions que comporte le bloc dans la direction z.

On peut supposer qu'il existe un intervalle moyen entre les porteurs de charge, les électrons ou les ions contenus dans le bloc 1 dans n'importe quelle direction et que cet intervalle est égal à une distance définie comme étant la distance d.

Le nombre total de porteurs de charge, d'électrons ou d'ions, ainsi qu'ils peuvent être diversement appelés, qui existent dans le bloc 1 de la figure 11, lequel ne constitue qu'une faible partie du canal conducteur dans un substrat donné, est donné par la relation suivante:

$$N_{total} = N_x N_y N_z = \frac{WLT}{d^3} \tag{1}$$

Or, $l/d^3$ peut être défini comme étant égal à $N_D$, la densité ou concentration de donneurs qui est le nombre d'ions, de porteurs de charge ou d'électrons par unité de volume à l'intérieur du bloc 1 existant dans le canal de conduction d'un substrat. La relation (1) peut donc s'écrire:

$$N_{total} = N_D WLT \tag{2}$$

La densité surfacique (ou dose) D des électrons, des porteurs de charge ou des ions dans un segment du plan x—y de la figure 11 existant dans une couche d'épaisseur T est définie par la relation suivante:

$$D = \frac{N_{total}}{WL} = N_D T \tag{3}$$

D'où, en extrayant $D_D$, densité volumique:

$$N_D = \frac{D}{T} \tag{4}$$

On déterminera ensuite le courant de canal $I_c$ qui traverse le bloc 1 de la figure 11.

Un faisceau de courant électrique d'une largeur égale à un unique électron est défini comme étant la variation de charge par unité de temps, dq/dt. Cela correspond au courant pris dans l'un des axes de la figure 11 et l'on supposera pour les besoins de la présente description que ce courant, $I_B$, existe le long de l'axe y sur la figure 11. En conséquence, le courant $I_B$ peut être défini comme suit:

$$I_B = \frac{dq}{dt} = \frac{dq}{dy} \frac{dy}{dt} \tag{5}$$

Cela peut également s'exprimer sous une autre forme, à savoir: le courant $I_B$ est égal à la charge unitaire q d'un électron multipliée par la vitesse $V$ du porteur de charge divisée par l'espacement d entre porteurs de charge successifs. En effet, on a:

$$\frac{dq}{dy} = q/d \text{ et } dy/dt = V \quad \text{Donc: } I_B = \frac{q}{d} V$$
$$(6) \qquad\qquad\qquad\qquad (7)$$

où $V$ est la vitesse moyenne des porteurs le long de l'axe y de la figure 11 et d est l'espacement moyen entre les porteurs qui constituent le faisceau d'électrons dirigé le long de l'axe y de la figure 11.

La relation (7) ci-dessus définit le courant effectif d'un faisceau d'une largeur d'un seul électron se déplaçant dans la direction y. Pour étendre ce faisceau à une feuille de courant dans toute la largeur du bloc selon l'axe x de la figure 11, on peut définir comme suit le courant de feuille $I_S$ d'une unique couche d'électrons traversant une telle surface:

$$I_S = I_B N_x \text{ ou } I_S = I_B \frac{W}{d} = \frac{q}{d} \frac{W}{d} V$$
$$(8)$$

Cela équivaut à dire qu'une feuille de courant se déplaçant dans la direction y est égale au courant

O 005 183

$I_B$ multiplié par le nombre d'électrons répartis le long de l'axe x et se déplaçant dans la direction y dans cette feuille, soit W divisé par l'espacement d entre électrons.

Le courant de canal total $I_C$ qui se déplace dans une direction donnée sur la figure 11 est égal au courant de feuille $I_S$ multiplié par le nombre d'électrons ou de porteurs répartis le long de l'axe z sur une épaisseur T pour donner le courant volumique total. Pour un courant de canal se déplaçant le long de l'axe y sur la figure 11, on a: $I_c = N_z I_s$. Cela peut egalément s'écrire:

$$I_c = \frac{T}{d} \frac{q}{d} \frac{W}{d} V, \quad \text{ou encore:} \quad I_c = N_D TWqV \tag{9}$$

où T est l'épaisseur du canal dans l'axe z.

La densité de porteurs dans une section plane d'épaisseur T a été définie comme étant égale à la densité volumique des porteurs: $N_D$ multipliée par l'épaisseur du bloc (cf. la relation (3) ci-dessus). Après substitution, la relation (9) devient donc:

$$I_c = DWqV \tag{10}$$

Cela revient à dire que le courant de canal total est égal au produit de la densité de porteurs par la largeur du canal, par la charge unitaire q et par la vitesse moyenne V des porteurs.

Le terme V peut être exprimé en supposant qu'il existe dans le canal un champ électrique longitudinal uniforme dans le sens du déplacement des porteurs de charge. Cette supposition crée effectivement une approximation du premier ordre du champ électrique effectif qui existe dans le canal dans le sens du déplacement des porteurs comme suit: si le champ électrique existant est $E_L$ et la mobilité des porteurs $\mu$, la vitesse V est définie comme étant le produit du champ électrique $E_L$ par la mobilité $\mu$. Une approximation du champ électrique existant dans un dispositif à canal de conduction du type décrit peut être obtenue, lorsqu'il existe une distance L séparant le drain de la source. Par conséquent:

$$E_L = \frac{V_{DS}}{L} \quad \text{et} \quad V = \mu \frac{V_{DS}}{L} \tag{11}$$

*Application des considérations théoriques*

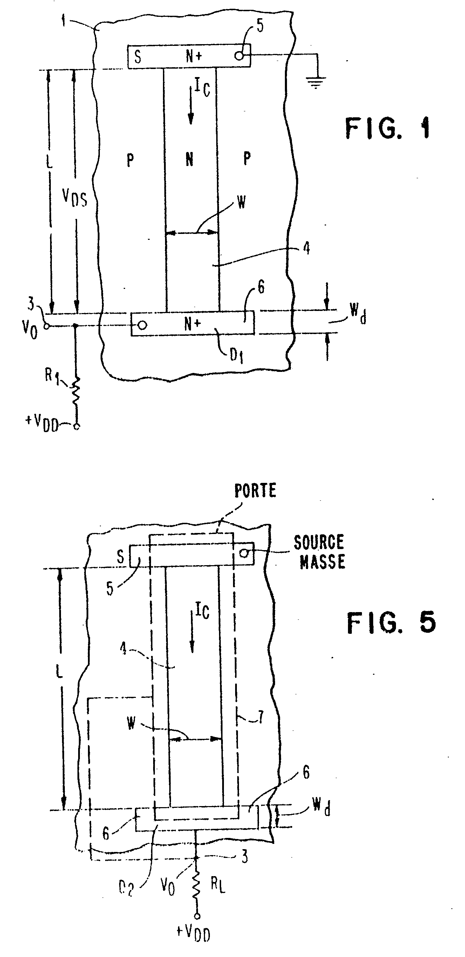

Les principes ci-dessus vont à présent être appliqués à un détecteur Vinhall à un seul canal dont une vue de dessus est représentée sur la figure 1. La demande de brevet européen publiée, citée ci-dessus est incorporée, à titre d'exemple de référence, dans la présente description. Ce détecteur comporte un canal de longueur totale L et de largeur totale W dans la région où le faisceau électronique est engendré; il est muni d'une source S et d'un drain $D_1$, qui sont formés à la surface d'un substrat en matériau semi-conducteur. Sur la figure 1, la source 5 est connectée, par exemple, au potentiel de la masse, elle est disposée à l'une des extrémités d'un canal de conduction 4 dont la largeur et la longueur viennent d'être décrites et qui se termine par un drain 6 ($D_1$). Ce drain est connecté à un circuit de sortie par l'intermédiaire d'une résistance $R_1$ de manière à obtenir par rapport à la masse une tension de sortie $V_o$ à la borne 3. Le drain 6 est connecté à une source de tension de drain $V_{DD}$ et la tension entre le drain 6 et la source 5, $V_{DS}$, doit être maintenue à une valeur inférieure à celle à laquelle se produit l'effet d'avalanche (ionisation par impact).

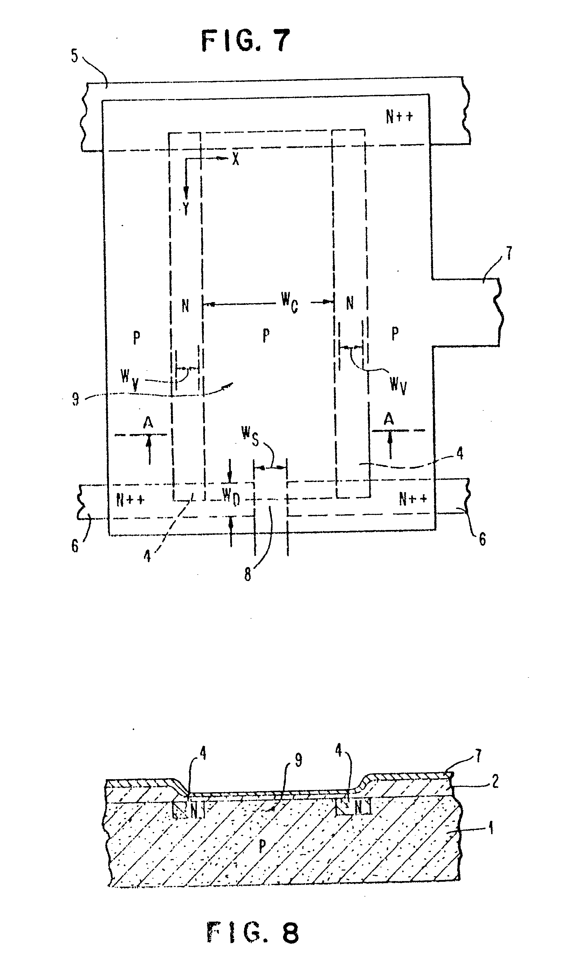

Dans la présente invention, deux canaux du genre de l'unique canal principal 4 de la figure 1 sont utilisés, mais un seul d'entre eux sera décrit, dans un but de simplicité. Une porte métallique ou un écran électrostatique 7 représenté en pointillés recouvre le canal 4 et est séparé de la surface du substrat par une mince couche d'oxyde. On sait que, dans le mode de fonctionnement dit d'enrichissement des dispositifs semi-conducteurs à effet de champ, la polarisation de porte est employée pour induire une densité de porteurs de charge suffisante pour former un canal de conduction entre la source et le ou les drains. Par contre dans le mode de fonctionnement dit à appauvrissement, le canal existe, en l'absence de polarisation de porte. Sur la figure 5, dans le cas d'une technologie faisant appel à l'emploi de silicium, un potentiel d'environ 10 volts, par exemple, serait utilisé aux fins du fonctionnement de la porte 7.

La largeur W, bien qu'elle ne soit pas représentée à l'échelle sur la figure, constitue de préférence la limite extrême de la résolution que les techniques actuelles permettent d'obtenir. La largeur $W_d$ du drain 6 est approximativement égale à W et ne peut donc pas être réduite davantage. Lorsque deux canaux Vinhall de ce type sont réalisés côte-à-côte, ainsi qu'on le verra mieux plus loin (figure 7), les drains seront séparés par une région 8 de largeur $W_s$.

On notera que l'on désire rendre les canaux 4 et les drains 6 aussi étroits que possible. La distance

7

$W_s$ sera aussi faible que possible. Etant donné que les techniques actuelles limitent la largeur d'un canal à une largeur déterminée W, la distance 8 sera égale en principe à W.

On étudiera à présent les conditions et les caractéristiques de fonctionnement d'un dispositif du type représenté sur la figure 1.

En combinant les relations (11), (9) et (10), on obtient les relations suivantes qui définissent le courant de canal:

$$I_c = N_D T \left(\frac{W}{L}\right) q\mu \ V_{DS} \quad \text{ou} \quad I_c = D \left(\frac{W}{L}\right) q\mu \ V_{DS}$$

$$(12A) \hspace{6cm} (12B)$$

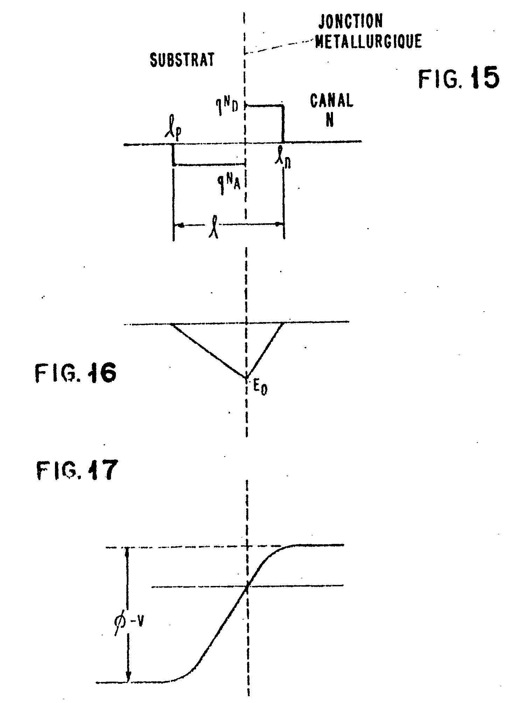

Les relations (12A) et (12B) ci-dessus définissent le courant de canal $I_c$ dans un dispositif du type représenté sur la figure 1. On sait que ce dernier présente une caractéristique de courant de canal telle que celle représentée par le graphique de la figure 14. Ce graphique est représentatif des transistors FET en général et présente plusieurs particularités bien connues telles que la région linéaire ou dite ohmique (1), la région de saturation (2) et la région de pincement (3) ainsi que la région d'ionisation par impact (4) qui conduit au phénomène d'avalanche. A partir du pincement, et malgré une augmentation de la tension entre le drain et la source, la conduction de courant n'augmente pas de façon importante jusqu'à ce que l'effet d'avalanche se produise, ce phénomène de rupture par avalanche (ou d'autres phénomènes analogues) se produit à des tensions drain-source très élevées. Le courant de canal lors de la saturation ou du pincement est donc défini comme suit:

$$I_{c_{Sat}} = N_D T \left(\frac{W}{L}\right) q\mu \ V_{Sat} \quad \text{ou} \quad I_{c_{Sat}} = D \left(\frac{W}{L}\right) q\mu \ V_{Sat}$$

$$(13A) \hspace{6cm} (13B)$$

Dans le cas de tensions drain-source qui, dans un canal, sont supérieures à la tension de pincement et inférieures à la tension d'avalanche, les relations définissant le courant de canal sont les suivantes:

$$I_c = N_D T \left(\frac{W}{L}\right) q\mu \ V_{Sat} \left(\frac{L}{L-L_D}\right) \quad \text{ou} \quad I_c = D \left(\frac{W}{L}\right) q\mu \ V_{Sat} \left(\frac{L}{L-L_D}\right)$$

$$(14A) \hspace{6cm} (14B)$$

En effet dans les relations ci-dessus, L est la longueur totale du canal entre la source 5 et les drains 6, cependant comme le comprendra l'homme de l'art, une région de pincement peut être formée dans un dispositif à canal de conduction et dans le cas présent cette région de pincement se formera à proximité des drains, créant ainsi une partie appauvrie de longueur $L_D$. La longueur effective de la partie non appauvrie du canal est donc ramenée à $L-L_D$. D'où le facteur correctif $L/L-L_D$.

La détermination du courant de canal dans un dispositif à effet de champ ou dans un dispositif à canal de conduction pour les différentes parties de son fonctionnement (voir la courbe représentant le courant de drain en fonction de la tension, figure 14) a précédement été décrite. A cet égard, on pourra se reporter à la demande de brevet No. 77 16788 déposée en France par la demanderesse le 25 mai 1977 (numéro de publication 2 357 073). Il suffit de dire ici que le relation entre le courant de drain ou le canal et la longueur de canal divisée par la longueur totale non appauvrie restante (laquelle longueur s'étend jusqu'à la région de pincement) a été analysée théoriquement et vérifiée expérimentalement, les relations ci-dessus étant une représentation précise du fonctionnement des dispositifs du type représenté sur la figure 1.

Lorsque le canal conducteur d'ùn dispositif du type représenté sur la figure 1 est formé au-dessous de la surface d'un substrat, une tension de pincement continue à exister mais doit être déterminée en fonction d'autres considérations. Ces dernières ne seront pas exposées ici de façon détaillée car on en trouvera une approximation dans l'étude, par S.M. Sze, d'un transistor à jonction à effet de champ (J—FET) parue dans l'ouvrage intitulé "Physics of Semiconductor Devices", page 341 et suivantes. La tension de pincement pour un dispositif J—FET, désignée $V_{D_{Sat}}$, s'exprime sous une forme modifiée de la façon suivante:

$$V_{D_{Sat}} = 3 \frac{qN_D T^2}{2\varepsilon_S} = 3 \frac{qDT}{2\varepsilon_S} \hspace{4cm} (15)$$

Dans la relation (15) $\varepsilon_S$ est la constante diélectrique du matériau semi-conducteur utilisé. Dans le cas du silicum, $\varepsilon_S$ est approximativement égale à $1,05 \times 10^{-10}$ Farads/m.

**0 005 183**

En substituant la relation (15) dans les relations (14A) et (14B) ci-dessus, on obtient:

$$I_c = 3(N_D T)^2 q^2 T \left(\frac{W}{L}\right) \frac{\mu}{2\varepsilon_s} \left(\frac{L}{L - L_D}\right) \quad \text{ou} \quad I_c = 3D_2 \left(\frac{W}{L}\right) q^2 T \frac{\mu}{2\varepsilon_s} \left(\frac{L}{L - L_D}\right)$$

$$(16A) \hspace{9cm} (16B)$$

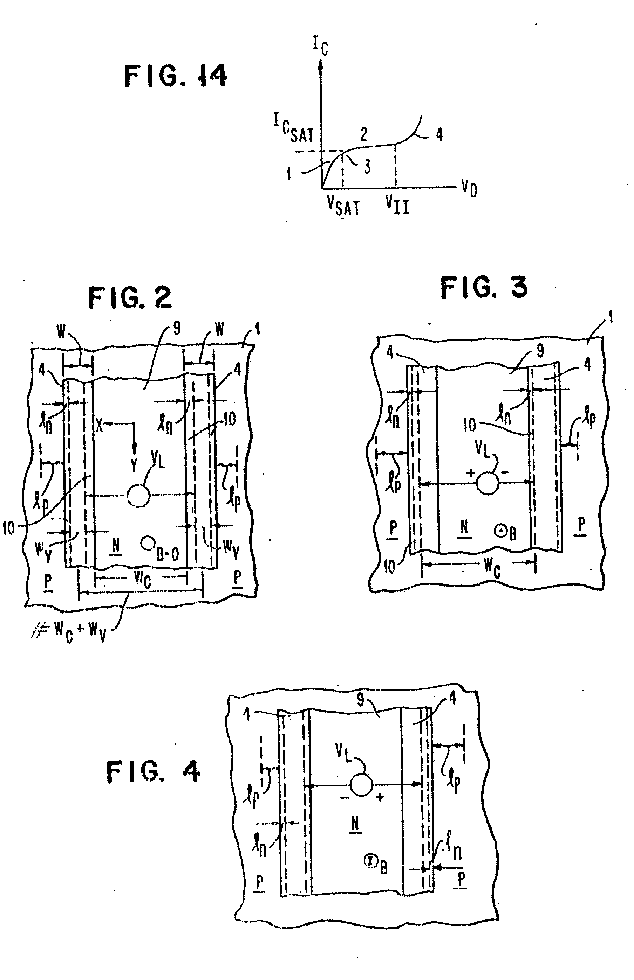

Les relations ci-dessus ayant été définies à partir des principes physiques fondamentaux qui caractérisent l'écoulement des porteurs de charge dans un dispositif à un canal semi-conducteur, on s'efforcera à présent de définir les principes de fonctionnement d'un dispositif Vinhall à deux canaux. Ainsi qu'on l'a précédemment observé, le déplacement des parois des régions d'appauvrissement du canal résulte de l'application de la tension de Lorentz à ces parois. La tension de Lorentz, $V_L$, (figures 2, 3 at 4) est le produit de la vitesse des porteurs $V$, du champ magnétique B et de la distance séparant les deux parois d'un même canal, précédemment définie comme étant la largeur Vinhall $W_v$:

$$V_L = V \, BW_v \tag{17}$$

Dans la région de pincement à proximité des drains, les porteurs atteignent une vitesse maximum ou de saturation, approximativement égale à $10^7$ cm/s. En conséquence, de façon approximative, pour une largeur Vinhall donnée $W_v = W - 21_n$ (où W est la largeur totale du canal et $1_n$ est la largeur de la région d'appauvrissement le long de chaque côté du canal) et pour un champ magnétique B donné, les côtés du canal se déplacent d'une distance maximum. Pour cette raison, il est souhaitable que le dispositif fonctionne dans le mode de pincement étant donné que la sensibilité du dispositif Vinhall atteint alors une valeur maximum.

La vitesse de saturation est atteinte dans les matériaux de type N à des intensités de champ électrique longidutinal plus faibles que dans le cas des matériaux de type P. Des canaux de type N ont donc été choisis. La relation (17) indique que la tension de Lorentz $V_L$ ne dépend pas du nombre de porteurs qui se déplacent dans le canal central de couplage, mais au contraire de leur vitesse. En d'autres termes, il est possible de créer une tension de Lorentz relativement importante tout en maintenant une faible densité de courant. Ceci est une caractéristique essentielle de la présente invention.

Ce principe est mis en oeuvre dans la présente invention en couplant de façon appropriée une tension de Lorentz à deux canaux Vinhall. On obtient ainsi un détecteur de champs extrêmement sensible. Le dispositif de base est représenté sur les figure 7 et 8, sur lesquelles deux canaux Vinhall 4 séparés l'un de l'autre relient une unique région de source 5 à deux régions de drain 6 distinctes. La source et les drains sont fortement dopés au moyen d'un matériau dont le type de conductivité est l'opposé de celui du matériau semi-conducteur constituant le substrat. Les canaux Vinhall 4 sont formés par exemple par une implantation ionique dans le substrat de manière à obtenir des canaux en forme de filament ou de bande. Ces canaux Vinhall sont réalisés de telle sorte que le volume de la région d'appauvrissement formée autour des canaux implantés constitue une partie importante de la section totale de ces canaux. De ce fait, toute modulation de la largeur des régions d'appauvrissement au moyen d'une tension de Lorentz se traduit par une modification d'une partie importante de la largeur des canaux. Les canaux Vinhall 4 sont interconnectés par un canal central 9 ici appelé "canal de couplage". Les caractéristiques de ce dernier sont très différentes de celles des canaux Vinhall. Les principales différences sont les suivantes:

1) La concentration de porteurs (implantés ou induits) est nettement plus faible dans le canal de couplage que dans les canaux Vinhall.

2) La largeur $W_c$ du canal de couplage est indépendante de la largeur Vinhall $W_v$.

Le courant total conduit par le canal de couplage est divisé entre les régions de drain. Cependant, il ne correspond qu'à une faible partie du courant de canal conduit par l'un ou l'autre des canaux Vinhall. La fonction essentielle du canal de couplage est de coupler une tension de Lorentz $VBW_c$ créée dans celui-ci aux deux canaux Vinhall. Le canal de couplage constitue le mécanisme qui permet de moduler la largeur des régions d'appauvrissement des canaux Vinhall.

La modulation de la largeur des régions d'appauvrissement est, semble-t-il, le principal phénomène qui se produit à l'intérieur des canaux Vinhall, particulièrement dans les régions de pincement voisines des drains. Ce phénomène sera décrit plus loin.

Comme on peut le voir sur la figure 7, le canal de couplage 9 est créé en inversant légèrement la surface du matériau semi-conducteur 1 à proximité immédiate des canaux Vinhall 4 et entre ces derniers. La couche d'inversion est créée en appliquant une tension de polarité appropriée à l'électrode de porte 7 qui est séparée du canal 9 par une mince couche d'oxyde 2. Comme le montre la figure 8, la couche 2 qui se trouve audessous de l'électrode de porte 7 recouvre les canaux 4. La principale raison de ce recouvrement réside dans le fait que les dimensions physiques des canaux Vinhall 4 sont très faibles, il est donc nécessaire de garantir un couplage électrique entre ces canaux 4 et le canal 9.

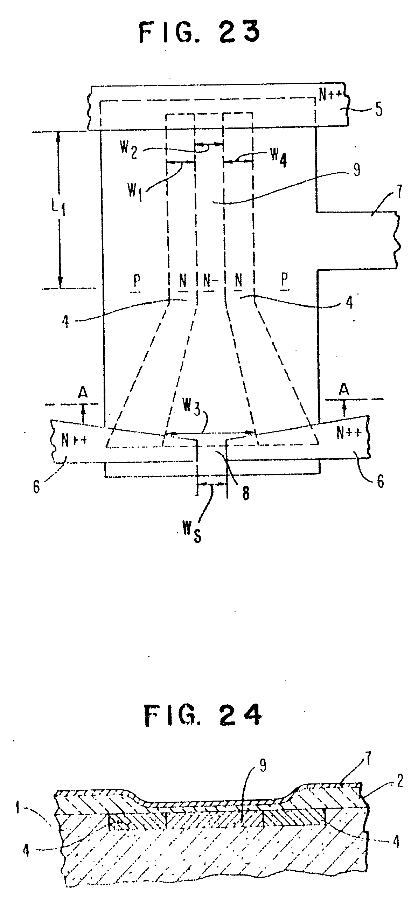

On a représenté sur les figures 23 et 24 une autre réalisation d'un dispositif à deux drains. Dans

9

cette dernière réalisation, le canal de couplage 9 est implanté, mais présente une concentration de porteurs inférieure à celle des canaux Vinhall 4.

On peut également voir sur la figure 8 que l'électrode de porte 7 recouvre la couche d'oxyde au-dessus des deux canaux Vinhall ainsi que le canal de couplage 9. Cette couche d'oxyde, dans sa partie épaisse permet de rendre le dispositif insensible aux champs électriques parasites ou indésirables; l'électrode de porte est surtout employée pour enrichir ou appauvrir la concentration des donneurs dans le canal de couplage afin de moduler la réponse du détecteur aux champs magnétiques.

La souplesse de fonctionnement du détecteur représenté sur la figure 7 est beaucoup plus grande que celle du dispositif à canal évasé représenté sur la figure 1 de la demande de brevet précitée No. 77 16788. Les équations et relations établies dans le cas du dispositif Vinhall à deux canaux peuvent aisément être modifiées pour définir la performance du dispositif à canal évasé, en supprimant simplement le terme afférent au canal de couplage.

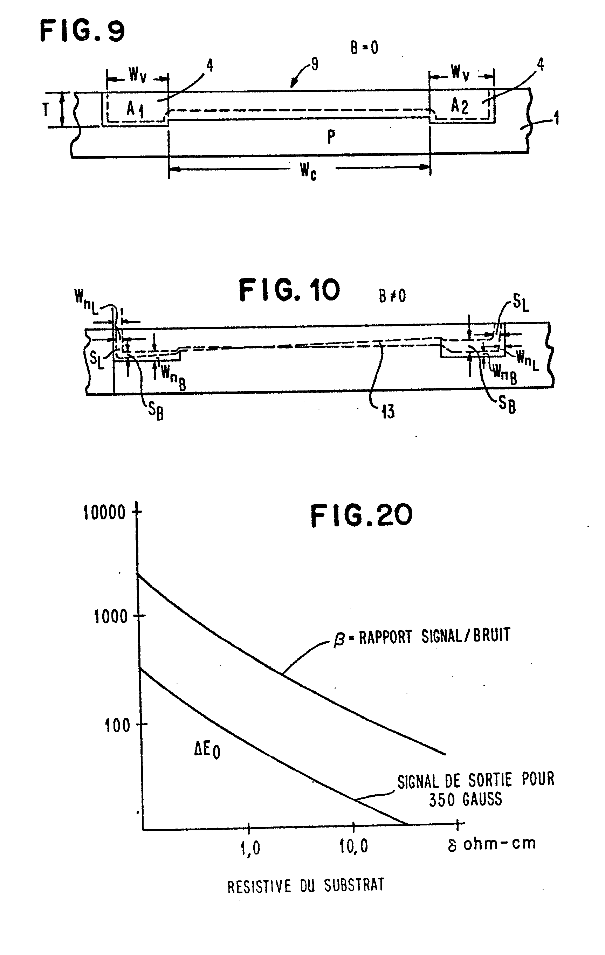

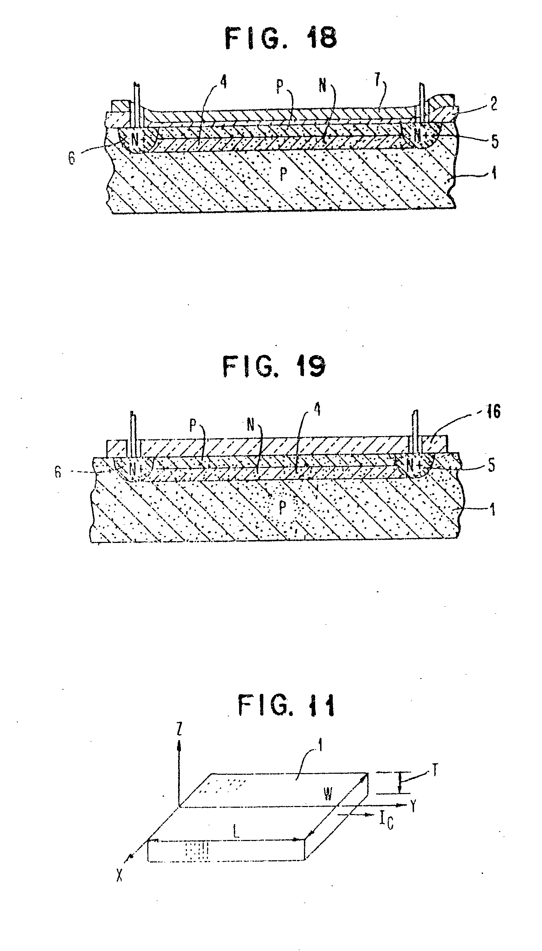

On a représenté sur les figures 9 et 10 des coupes plus détaillées du dispositif de la figure 7 qui permettent de voir les deux canaux Vinhall 4 et le canal de couplage 9 qui interconnecte ces derniers. Ces figures correspondent à une coupe prise suivant la ligne A—A de la figure 7. La ligne en trait plein qui figure au-dessous de la surface du substrat représente la jonction métallurgique entre le substrat 1 et la région des canaux. Les canaux Vinhall 4, qui se trouvent aux extrémités droite et gauche sont réalisés par implantation ionique. Le canal de couplage 9 peut également être réalisé par implantation ionique ou par inversion des charges au moyen d'une électrode de porte 7. Cette dernière, qui n'est pas représentée, est séparée de la surface du substrat 1 par une mince couche d'oxyde 2 (non représentée). Dans un cas comme dans l'autre, le canal de couplage 9 se trouve couplé électriquement aux deux canaux Vinhall 4. La ligne pointillée que l'on peut voir sur les figures 9 et 10 délimite les régions d'appauvrissement qui se forment le long des côtés et de la partie inférieure des canaux, et correspond à la fin du processus d'appauvrissement qui a lieu dans les trois canaux. La largeur $W_n$ de la région d'appauvrissement (qui correspond au l de la figure 16), formée dans l'un ou l'autre des canaux 4 est donnée par le relation (18):

$$W_n = [\frac{2\varepsilon_s}{q} (\phi + V_D(y) \pm V_L(y)) (\frac{N_A}{N_A+N_D}) \frac{1}{N_D}]^{1/2} \qquad (18)$$

où:

$\phi$      est la hauteur de la barrière de potentiel encore appelée tension de diffusion

$$\phi = \frac{KT_0}{q} Ln (\frac{N_A N_D}{N_i^2})$$

$V_D(y)$    est la tension de drain mesurée en un point qui se trouve à une distance y déterminée du point de référence de la source.

$V_L(y)$    est la tension de Lorentz appliquée en ce même point,
$K$        la constante de Boltzmann,
$T_0$      la température en degrés Kelvin, et
$Ln$     le logarithme népérien.

La relation (18) correspond approximativement au mécanisme d'appauvrissement car elle suppose que la charge d'espace, le champ électrique et le potentiel de jonction se comportent conformément aux hypothèses usuelles qui sont respectivement illustrées par les figures 15 à 17. Il convient à présent d'étudier le mécanisme de formation des régions d'appauvrissement et de déterminer la façon dont ce mécanisme peut être affecté par une tension de Lorentz de telle sorte qu'un signal différentiel soit créé dans les détecteurs Vinhall à deux canaux de conduction.

On a représenté à titre d'exemple sur la figure 2 une partie d'un ensemble constitué par deux canaux Vinhall 4 et par un canal de couplage 9, cet ensemble étant formé dans un substrat semi-conducteur 1. Ce dernier est du type P et le canal du type N. La source 5 et les drains 6 ne sont pas représentés. Cette source et ces drains seraient du type N$^+$ et réalisés au moyen de techniques bien connues de manière à obtenir un dispositif fonctionnant dans le mode d'enrichissement ou dans le mode d'appauvrissement.

On observera que des jonctions P—N existent le long des limites du canal ainsi qu'au niveau de la source et des drains partout où un matériau de type N est adjacent à un matériau de type P.

Ainsi qu'on le verra plus loin, il existe une région d'appauvrissement au voisinage de toutes les jonctions P—N du dispositif, y compris sa partie inférieure, ses extrémités et dans certains cas sa partie supérieure, du canal conducteur lui-même. L'analyse ici donnée ne tient pas compte de la modulation en profondeur des régions d'appauvrissement dans les parties supérieure et inférieure du canal. Cette simplification n'affecte pas de façon appréciable la compréhension du mécanisme de l'invention. On notera cependant qu'il conviendrait de modifier légèrement les expressions relatives à la modulation de la largeur de la région d'appauvrissement aux fins d'une analyse tri-dimensionnelle.

10

On sait qu'une couche d'appauvrissement se forme au voisinage d'une jonction P—N. Sur la figure 2, les régions d'appauvrissement formées à l'intérieur du matériau de type N sont représentées par des lignes pointillées à l'intérieur des canaux 4 et sont désignées par la référence 10. Les régions 10 sont donc formées le long des jonctions P—N intérieures et se développeraient dans la source et les drains. On supposera provisoirement ci-après que les canaux Vinhall 4 ne sont pas connectés par le canal de couplage 9, afin que le mécanisme de formation des régions d'appauvrissement puisse être clairement décrit. Cependant lorsque le canal de couplage 9 est actif, les bords internes des canaux 4 présentent des régions d'appauvrissement dont les limites sont celles indiquées sur les figures 9 et 10, et non plus sur les figures 2 à 4. La largeur de la région d'appauvrissement dans la région N 10 est désignée par $1_n$. Une région analogue existe dans le matériau de type P qui entoure le canal, et sa largeur est désignée par $1_p$.

En ce qui concerne plus particulièrement les régions d'appauvrissement 10 des canaux 4, qui existent le long du canal de couplage, on notera que les électrons ne se déplacent que dans la partie non appauvrie de chaque canal. La largeur de cette dernière sera donc plus étroite de $2\ 1_n$.

La partie conductrice du canal 4 est dite ici "largeur Vinhall", $W_v$, et par commodité de façon approximative est définie comme suit:

$$W_v = W - 2\ 1_n$$

Le potentiel de charge d'espace, le champ électrique et la répartition des charges à proximité d'une jonction P—N entre le canal et le substrat, sont montrés sur les figures 15, 16 et 17. La jonction PN est du type abrupte, avec une polarisation extérieure V.

Les figures 15 à 17 sont alignées sur un axe vertical désigné "jonction métallurgique". Cette jonction est également dite limite stochastique ou partie de la jonction P—N où les concentrations de donneurs et d'accepteurs sont égales. Sur la figure 15, la charge d'espace est représentée sous la forme d'une charge positive $(qN_A)$ et d'une charge négative $(qN_D)$ distribuées autour de la jonction métallurgique, la charge positive se trouvant dans la région de type N et la charge négative dans la région de type P. La nature de la distribution de cette charge n'est pas parfaitement comprise et n'est représentée que sous la forme d'une approximation grossière sur la figure 15 (dite approximation de Shockley). Seules des observations d'un caractère général peuvent donc être formulées à partir de cette figure. Premièrement, des régions d'appauvrissement de largeurs différentes $1_p$ et $1_n$ existent respectivement dans les matériaux de type P et de type N en fonction, respectivement, des concentrations des accepteurs et des donneurs. Deuxièmement, l'importance de la charge d'espace dans lesdites régions est le produit de la concentration des donneurs $(N_D)$ par la charge des porteurs (q). De même, dans la région de type P, la concentration des accepteurs est égale au produit de la concentration des accepteurs $(N_A)$ par la charge électrique (q). Selon la convention adoptée en ce qui concerne le signe de la charge, la charge d'espace dans la région de type P est de signe plus (ou de signe moins), et celle de la région de type N est de signe moins (ou de signe plus), respectivement. Selon la convention ici adoptée, la charge est positive dans la région de type N et négative dans la région de type P.

La figure 16 représente le champ électrique qui existe au voisinage de la jonction métallurgique PN.

Le champ électrique peut être déterminé en appliquant la loi de Gauss à la distribution de la charge d'espace représentée sur la figure 15. Le champ électrique ainsi déterminé est celui représenté sur la figure 16. L'expression représentée sur cette dernière figure permet d'obtenir la variation du potentiel par intégration. Cette variation est montrée sur la figure 17.

Ce potentiel est intéressant parce que c'est lui qui détermine la largeur de la région d'appauvrissement de part et d'autre de la jonction métallurgique et doit être parfaitement compris avant qu'une expression de la modulation de la largeur des régions d'appauvrissement puisse être définie.

Sur la figure 17, on a représenté la forme de la barrière, le potentiel qui existe en un point de potentiel. La hauteur de la barrière de potentiel ou tension de diffusion s'écrit de façon connue:

$$\phi = \frac{KT_0}{q}\ Ln\left(\frac{N_A N_D}{N_i^2}\right) \tag{19}$$

de même la valeur de $\quad E_0 = -\left[\dfrac{2q}{\varepsilon_s}(\phi - V)\dfrac{N_D N_A}{N_D + N_A}\right]^{\frac{1}{2}}\quad$ et $\quad 1 = \left[\dfrac{2\varepsilon_s}{q}(\phi - V)\left(\dfrac{N_D + N_A}{N_D N_A}\right)\right]^{\frac{1}{2}}$

où Ln est le logarithme népérien, K est la constante de Bolzmann, $T_0$ est la température en degrés Kelvin et $N_i$ est la densité intrinsèque des porteurs dans le substrat $(N_i^2 = 10^{27})$, $\varepsilon_s$ est égal au produit de la permittivité du vide $\varepsilon_0$ par la constante diélectrique du substrat (silicium) $\varepsilon_r$.

L'expression ci-après permet d'obtenir une valeur approximative de la largeur $1_n$ de chaque région d'appauvrissement que comporte le canal 4, sachant que:

$$1_n = 1 \frac{N_A}{N_A + N_D} \quad \text{on trouve} \quad 1_n = [\frac{2\varepsilon_S}{q}(\phi - V) \frac{N_A}{N_A+N_D} \frac{1}{N_D}]^{1/2}$$

(20)

on rappelle que la tension V est la tension externe appliquée à la jonction P—N.

L'obtention d'une valeur précise est fonction de la distribution effective de la charge d'espace (donneurs et accepteurs) qui serait formée à proximité immédiate des jonctions métallurgiques constituant les limites des régions d'appauvrissement. La forme et la distribution de ces régions sont actuellement inconnues. L'expression donnée ci-dessus est la meilleure dont on dispose actuellement (voir l'ouvrage de P.E. Gray et al, intitulé "Physical Electronics and Circuit Models of Transistors", pages 8 à 23, publié en 1964 par John Wiley and Sons, New York).

Dans l'expression ci-dessus, $N_D$ est la concentration des donneurs dans le canal, $N_A$ est la concentration des accepteurs dans le substrat qui entoure le canal, $\varepsilon_S$ est la constante diélectrique pour le matériau employé et q est la charge d'un électron.

Ainsi qu'on l'a déjà indiqué, la largeur effective de la partie conductrice du canal 4 est égale en première approximation à sa largeur physique W moins deux fois la largeur $1_n$ des régions d'appauvrissement. Ou, si l'on préfère, la largeur Vinhall $W_v$ est définie comme suit:

$$W_v = W - 2 [\frac{2\varepsilon_S}{q}(\phi - V) \frac{N_A}{N_A+N_D} \frac{1}{N_D}]^{1/2}$$

(21)

Il ressort de l'expression (21) que la largeur de la région d'appauvrissement $1_n$ qui se trouve le long de chaque côté du canal est fonction d'une tension V de modulation qui est appliquée de façon externe à la jonction. Cette tension peut être créée à l'intérieur du canal par suite du champ de Lorentz $VB$ qui est formé dans un canal présentant une largeur Vinhall $W_v$. La tension de Lorentz $V_L = VBW_v$ est dirigée dans la direction x, c'est-à-dire perpendiculairement aux équipotentielles, en supposant que les porteurs se déplacent dans le canal dans la direction y et qu'un champ magnétique soit appliqué perpendiculairement au canal.

La figure 2 illustre la création et l'application de la tension de Lorentz $V_L$ qui agit dans la direction x vers les limites latérales des régions d'appauvrissement qui se trouvent le long des côtés de chaque canal 4. Cette tension est créée à l'intérieur du canal de couplage 9 lorsque celui-ci est actif.

La définition générale de la tension de Lorentz $V_L$ est donnée sous la forme d'une intégrale curviligne

$$V_L = c \int_{-\frac{W}{2}}^{+\frac{W}{2}} (V_y \times B_z) . dx$$

prise entre les jonctions P—N qui forment les côtés du canal. Les régions d'appauvrissement 10 qui existent le long de chacun des côtés de chaque canal 4 de la figure 2 sont représentées ici avant l'application d'un champ magnétique perpendiculairement au plan de la figure et donc avant la création d'un canal de couplage 9. Lorsque ce dernier est actif, les régions d'appauvrissement 10 qui se trouvent le long des côtes du canal 9 n'existent pas et la tension de Lorentz est créée au travers d'une largeur $W_c$ du canal 9 plus une moitié de $W_v$ de chacun des canaux 4 soit $V_B (W_c+W_v)$.

Si un champ magnétique est appliqué aux canaux 4 et 9 perpendiculairement au plan de la page, on obtient dans le canal 9 une tension de Lorentz qui, conformément à l'expression (20) ci-dessus, modifie la largeur $1_n$ des régions d'appauvrissement 10 le long de chaque côté du canal 9. Avec le sens représenté sur la figure 3, le champ magnétique produit une modulation de la largeur des régions d'appauvrissement, les limites de cas dernières dans les canaux 4 se déplacent toutes deux vers la gauche d'une même distance, ce qui a pour effet de déplacer les parties conductrices des canaux 4. La situation inverse est représentée sur la figure 4, où le champ magnétique est inversé et les limites effectives des régions d'appauvrissement sont déplacées vers la droite.

Le phénomène décrit ci-dessus est particulièrement intéressant puisque les limites de régions, qui étaient sensées être fixes, font en réalité l'objet d'un déplacement alors que les porteurs eux-mêmes contenus dans le canal ne sont pratiquement pas déviés par le champ de Lorentz.

**O 005 183**

Il est intéressant de calculer la relation approximative qui existe et de déterminer le déplacement des limites du canal, dans la direction x, lorsqu'une tension de Lorentz est appliquée.

On va maintenant déterminer la mesure dans laquelle le signal de sortie du dispositif Vinhall à deux canaux de conduction est affecté par le déplacement des limites des régions d'appauvrissement sous l'effet d'une tension de Lorentz créée dans le canal de couplage 9.

La principale régions du canal qui présente un intérêt est proche des drains lorsque $y \rightarrow L$. A ce point, et lorsqu'une tension drain-source suffisante est appliquée, un pincement se produit et la profondeur du canal diminue jusqu'à une valeur ultime définie comme étant la longueur de Debye.

L'application, perpendiculairement aux canaux, d'un champ magnétique d'induction B a pour effet de créer une tension de Lorentz dans le canal de couplage 9 (de largeur $W_c$) et dans les deux canaux Vinhall 4 dont chacun a une largeur $W_v$ ainsi que cela apparaît sur les figures 9 et 10. Lorsque le canal de couplage 9 est actif, les jonctions P—N les plus proches de lui et les régions d'appauvrissement cessent électriquement d'exister et la largeur effective du canal 9 devient: $W_c + W_v$, chacun des canaux 4 ajoutant une largeur de $W_v/2$ à celle du canal 9. Cette tension de Lorentz induite provoque un déplacement d'une distance S des limites des régions d'appauvrissement, comme l'indique la ligne pointillée sur la figure 10. La ligne pointillée représente les limites statiques des régions d'appauvrissement qui existent en l'absence d'un champ magnétique appliqué vers le bas. La ligne pointillée de la figure 10 correspond à celle de la figure 9.

Dans l'analyse ci-après, on n'a pas tenu compte du déplacement, à l'intérieur du canal de couplage 9, des limites des régions d'appauvrissement induites par la tension de Lorentz. Le canal 9 est légèrement dopé par comparaison avec les canaux de Vinhall 4. De ce fait, la modulation de la largeur des régions d'appauvrissement dans le canal de couplage 9 ne provoque qu'une variation de courant négligeable au niveau des drains 6. Une valeur approximative des amplitudes relatives des courants de canal dans les canaux 4 qui ont été modifiés magnétiquement peut être obtenue en déterminant les surfaces $A_1$ et $A_2$ représentées en coupe sur la figure 10. Ces surfaces sont déterminées comme suit, T étant l'épaisseur (la profondeur) des canaux, $S_L$ et $S_B$ seront définis ci-après:

$$A_1 = (W - Wn_L + S_L)(T - Wn_B + S_B) \tag{22}$$

$$A_2 = (W - Wn_L + S_L)(T - Wn_B + S_B) \tag{23}$$

où:

$S_L$ est la distance dont se déplacent les limites des régions d'appauvrissement le long des côtés du canal, en réponse à l'application d'une tension de Lorentz,

$S_B$ est la distance dont se déplacent les limites des régions d'appauvrissement le long de la partie inférieure du canal, directement au-dessous du centre des canaux de Vinhall, en réponse à l'application d'une tension de Lorentz.

$W_{nL}$ et $W_{nB}$ ont des définitions voisines et ces facteurs apparaissent clairement sur la figure 10.

$Wn_L$ et $Wn_B$ étant respectivement les dimensions de la largeur de la couche d'appauvrissement dans les directions horizontales et verticales.

Le rapport de la variation par incrément du courant de canal ($\Delta I_v$), produite par un champ magnétique, au courant de repos de canal ($I_v$), c'est-à-dire:

$$\frac{\Delta I_v}{I_v}$$

défini la sensibilité magnétique du dispositif.

Cette sensibilité magnétique, $\eta_v$, est définie au moyen de l'expression (24):

$$\eta_v = \frac{\Delta I_v}{I_v} = \frac{2(A_1 - A_2)}{A_1 + A_2} \tag{24}$$

où comme on l'a vu:

$I_v$ est le courant de canal nominal du canal Vinhall

$\Delta I_v$ est la modification, induite magnétiquement par incréments, du courant de canal du canal Vinhall.

En développant les expression (22) et (23), puis en formant leur somme et leur différence, on obtient:

$$A_1 + A_2 = 2[(W - Wn_L)(T - Wn_B) + S_L S_B] \tag{25}$$

$$A_1 - A_2 = 2[S_B(W - Wn_L) + S_L(T - Wn_B)] \tag{26}$$

13

En substituant les expressions (25) et (26) dans l'expression (24), on obtient l'expression désirée définissant la sensibilité magnétique $\eta_v$:

$$\eta_v = \frac{\Delta I_v}{I_v} = \frac{2\,[S_B(W - Wn_L) + S_L\,(T - Wn_B)]}{(W - Wn_L)\,(T - Wn_B) + S_L S_B} \qquad \eta_v \simeq \frac{2\,[S_B(W_v) + S_L\,(T - Wn_B)]}{W_v\,(T - Wn_B) + S_L S_B}$$

$$(27)$$

car il est évident que $W \gg Wn_L$ et $W \gg Wn_B$.

Une nouvelle simplification de l'expression (27) peut être obtenue en supposant que $S_L S_B \ll W_v$ $(T - Wn_B)$. Il s'agit en l'occurrence d'une supposition raisonnable étant donné que $S_B$ peut être du même ordre de grandeur que $T - Wn_B$, mais que $S_L$ est beaucoup plus petit que la largeur Vinhall $W_v$, compte tenu en particulier du fait que la valeur de $S_l$ est proportionnelle à $W_v$. L'expression (27) peut alors s'écrire:

$$n_v = 2\left(\frac{S_B}{T - Wn_B} + \frac{S_L}{W_v}\right)$$

$$(28)$$

L'expression (28) montre que la sensibilité du dispositif Vinhall à deux canaux de conduction est fonction de deux facteurs. Le premier de ces facteurs

$$\frac{S_B}{T - Wn_B}$$

définit le rapport de la modulation de la profondeur des régions d'appauvrissement à la profondeur de la région d'appauvrissement à l'intérieur du canal. Le second facteur définit le rapport de la modulation de la largeur des régions d'appauvrissement à la largeur Vinhall $W_v$. En raison de ce que l'on vient juste de dire ce second facteur devient insignifiant par comparaison avec le premier à proximié des drains lorsqu'on provoque un pincement. En pareil cas, le facteur de profondeur $T - Wn_B$ tend vers l'épaisseur limite de la région d'appauvrissement qui a précédemment été mentionnée sous l'appellation de longueur de Debye. S'il n'y avait pas cette limite, la sensibilité définie par l'expression (28) atteindrait une valeur extrêmement élevée. En l'occurrence, la longueur de Debye est d'un ordre de grandeur supérieure à la distance maximum de modulation de largeur, $S_B$, et égale à une fraction de l'épaisseur T du canal implanté. En conséquence, la sensibilité maximum du dispositif Vinhall est de l'ordre de 10% (ce qui constitue en fait un pourcentage très important).

L'expression (29) ci-après définit la longueur de Debye $T_D$:

$$T_D = \operatorname*{Lim}_{Y \to L} (T - Wn_B) = \left(\frac{\varepsilon K\,T_o}{q^2 N_i}\,(\frac{N_i}{N_{Ds}})^{\frac{1}{2}}\right)$$

$$(29)$$

où:

$\varepsilon$   = constante diélectrique du silicium
K   = constante de Boltzmann
$T_o$ = température (en degrés Kelvin)
q = charge des électrons; $1,6 \times 10^{-19}$ Coulombs
$N_i$   = concentration intrinsèque des porteurs, $1,8 \times 10^{-10}$ cm$^{-3}$ pour le silicium.
$N_{Ds}$ = concentration des donneurs à la surface du canal

Dans le cas où la température ambiante est de 300°K et où le substrat est en silicium, l'expression (29) permet d'obtenir la valeur de $T_D$ ci-après:

$$T_D = \operatorname{Lim} (T - Wn_B) = 35 \times 10^{-4}\left(\frac{N_i}{N_{Ds}}\right)^{\frac{1}{2}}$$

$$(30)$$

Pincement

En remplaçant le terme $T - Wn_B$ dans l'expression (28) dont seul le premier terme est conservé par sa valeur dans l'expression (30), on obtient:

$$\text{Lim } \eta_v = 2 \, S_B \, (2.86 \times 10^{+2}) \left( \frac{N_{Ds}}{N_i} \right)^{\frac{1}{2}} \tag{31}$$

$$(Y \rightarrow L)$$

Pour récapituler: la sensibilité du détecteur Vinhall à deux canaux de conduction est fonction de la modulation de la largeur et de la profondeur des régions d'appauvrissement de ces canaux. Cependant, en ce qui concerne les positions du canal qui se trouvent à proximité des drains où un pincement est induit, la sensibilité du détecteur est essentiellement fonction d'une modulation de la profondeur de la région du canal qui fait l'objet d'un pincement. En d'autres termes, la tension de Lorentz permet de moduler la longueur de Debye de la région de pincement. Il s'agit là d'une observation importante car il est à présent évident que la profondeur des canaux dans la région de pincement constitue un facteur essentiel qui explique la sensibilité élevée dudit détecteur Vinhall.

L'étape suivante de l'analyse consiste à exprimer le terme $S_B$ contenu dans la relation (31) et qui définit la modulation de la profondeur des régions d'appauvrissement. La relation (18) définit la largeur (ou la profondeur) de la région d'appauvrissement à l'intérieur du canal. La relation (18) comporte trois termes de tension: la tension de diffusion $\phi$, la tension drain-source $V_D(y)$ et la tension de Lorentz $\pm V_L(y)$. Cette dernière tension est obtenue à partir d'une intégrale curviligne et sa valeur approximative est donnée par la relation (32) ci-après:

$$V_L(y) = V(y) \, B(y) \, [W_c + W_v(y)] \tag{32}$$

où:

    $V(y)$ est la vitesse moyenne des porteurs qui se déplacent dans le canal Vinhall, mesurée au point y situé à une distance déterminée du point de référence de la source,

    $B(y)$ est l'intensité du champ magnétique appliqué perpendiculairement au canal Vinhall audit point y,

    $W_v(y)$ est la largeur Vinhall du canal audit point y, et

    $W_c$ est la largeur du canal de couplage.

La moitié de la tension de Lorentz définie par le relation (32) permet de moduler le canal Vinhall 4 gauche cependant que l'autre moitié de cette tension permet de moduler le canal Vinhall droit.

Dans la région de pincement du canal de couplage 9 et des canaux Vinhall 4, la tension de Lorentz totale devient:

$$V_L = V_s \, B \, (W_v + W_c) \tag{33}$$

Le terme de vitesse $V(y)$ que comporte la relation (32) correspond à la vitesse de saturation moyenne $V_s$ définissant la vitesse des porteurs dans la région de pincement du canal.

La relation définissant la modulation de la profondeur des régions d'appauvrissement $S_B$, au moyen d'un champ magnétique est donnée sous une forme différentielle par la relation (34):

$$S_B = \frac{dW_n}{dB} = \frac{\partial W_n}{\partial V_L} \frac{dV_L}{dB} \quad \text{Les termes:} \quad \frac{dV_L}{dB} \text{ et } \frac{\partial W_n}{\partial V_L} \tag{34}$$

peuvent être respectivement obtenus à partir des relations (33) et (18).

Le résultat est fourni par la relation (35):

$$S_B = \frac{1}{2} B V_s (W_c + W_v) \left( \frac{K_o}{V_p} \right)^{1/2} \quad \text{où:} \quad K_o = \frac{2\varepsilon_s}{q} \frac{N_A}{N_A + N_D} \frac{1}{N_D} \text{ et} \tag{35} \tag{36}$$

$V_p$ = tension de pincement

Les autres termes de tension, $\phi$ et $V_L$, qui figuraient dans la relation (18), n'apparaissent pas dans la relation (35) car ils sont en fait négligeables dans le cas d'un pincement; c'est-à-dire:

$$V_D(L) = V_p \gg \phi \pm V_L \tag{37}$$

L'étape suivante de l'analyse consiste à obtenir une expression définissant la tension de pincement. La question se pose à présent de savoir si les canaux Vinhall ou le canal de couplage ont été implantés ou ont été créés en induisant des charges (effet d'inversion) comme cela se fait normalement en technologie FET en appliquant une tension à une porte. Dans le cas de l'application d'une tension de porte, $V_g$, une valeur approximative de la tension de pincement, $V_p$, peut être simplement obtenue comme suit:

$$V_p \simeq = V_g - V_T = V'_g \qquad (38)$$

où $V_T$ est la tension de seuil. Si, au contraire, le canal de couplage a été implanté, la tension de pincement $V_p$ est obtenue de la façon ci-après.

*Tension de pincement dans les dispositifs fonctionnant en mode d'appauvrissement*

Le procédé le plus simple qui permet d'obtenir une valeur approximative de la tension de pincement $V_p$ dans le cas d'un canal implanté, consiste à utiliser comme point de départ la relation (18) et à substituer la profondeur moyenne, $\overline{T}$, du canal métallurgique (ou stochastique) à la profondeur d'appauvrissement, $W_n$, ce qui donne:

$$\overline{T} = \left[ \frac{2\varepsilon_s}{q} (\phi + V_p \pm V_L) \frac{N_A}{N_A + N_D} \frac{1}{N_D} \right]^{1/2} \qquad (39)$$

A proximité des régions de drain, $V_p >> \phi \pm V_L$. Par conséquent, la relation (39) peut être simplifiée comme suit:

$$\overline{T} = \left[ \frac{2\varepsilon_s}{q} (V_p) \frac{N_A}{N_A + N_D} \frac{1}{N_D} \right]^{1/2} \qquad (40)$$

Il semblerait qu'il ne reste á présent qu'à extraire $V_p$ de la relation (40). Il faut cependant étudier au préalable la signification du terme concentration de donneurs, $N_D$, dans la relation (40).

Les notions de longueur de Debye et de pincement nécessitent une étude de la distribution de la concentration des donneurs en fonction de la profondeur et en particulier de la concentration des donneurs à la surface du substrat.

On se reportera à présent à la figure 12 qui représente un profil typique de la concentration des porteurs, dans le cas d'une implantation, en fonction de la profondeur mesurée à partir de la surface du substrat.

Trois concentrations de donneurs différentes ont été indiquées: concentration de surface $N_{Ds}$, concentration moyenne $\overline{N}_D$, et concentration de pointe ou de crête $N_{Dp}$. La profondeur minimum de la couche d'appauvrissement définie comme étant une longueur de Debye, et précédemment décrite, est fonction de la concentration à la surface, $N_{Ds}$. Il est indispensable que cette dernière soit égale ou supérieure à la concentration dans le substrat, $N_A$, faute de quoi les conditions de longueur de Debye que l'on suppose exister lors du pincement pourraient ne plus s'appliquer.

En redonnant au terme $N_D$ ses véritables expressions en fonction de $\overline{N}_D$ et $N_{Ds}$ d'après les enseignements de la figure 12 et en extrayant la tension de pincement, $V_p$, de la relation (40), on obtient:

$$V_p = \frac{\overline{T}^2 q}{2\varepsilon_s} \frac{\overline{N}_D}{N_A} (N_A + N_{Ds}) \qquad (41)$$

La relation (42), ci-après, sera écrire en fonction de la dose D et non des concentrations des accepteurs et des donneurs, $N_A$ et $N_D$, respectivement. Il s'agit en l'occurence d'un outil particulièrement utile lorsqu'on désire réaliser de tels dispositifs fonctionnant soit dans le mode d'enrichissement, dans lequel l'application d'une tension de porte de commande induit la formation d'un canal par les porteurs, soit dans le mode d'appauvrissement, dans lequel des techniques de dopage ou d'implantation ionique sont utilisées pour créer un canal dans le substrat. La dose cumulée est en général une variable connue, lors de l'emploi de tels procédés, alors que les concentrations des accepteurs et des donneurs le sont beaucoup moins ou sont plus difficiles à déterminer.

La dose d'implantation D requise pour créer les concentrations désirées de donneurs ou d'accepteurs peut être exprimée en fonction du produit de la profondeur moyenne du canal, T, et de la concentration moyenne des donneurs, $\overline{N}_D$, soit $D = \overline{N}_D \overline{T}$. En utilisant

$$\overline{T} = \left( \frac{D}{N_D} \right)$$

16

dans la relation (41), on obtient la relation (42) qui est l'expression désirée de la tension de pincement dans le canal implanté, $V_p$:

$$V_p = \frac{D\overline{T}q}{2\varepsilon_s} \, \frac{N_A + N_{D_s}}{N_A} \tag{42}$$

où: $\varepsilon_s$ est la constante diélectrique du substrat.

Cette expression peut être utilisée pour déterminer les conditions de pincement pour les canaux Vinhall ainsi que pour le canal de couplage.

On peut à présent résoudre l'équation (35) afin d'obtenir l'expression désirée de la modulation de la profondeur des régions d'appauvrissement, $S_B$. En remplaçant dans l'équation (35) le terme $V_p$ par sa valeur dans l'équation (42) et le terme $K_0$, (préalablement modifié de manière à inclure la notation afférente à la concentration des donneurs à la surface, $N_D = N_{D_s}$), par sa valeur dans l'équation (36), on obtient:

$$S_B = \frac{BV_s \, (W_c + W_v)}{2} \, (\frac{\varepsilon_s}{qD}) \, (\frac{N_A}{N_A + N_{D_s}}) \tag{43}$$

En substituant l'équation (43) dans l'équation (31), on obtient l'expression désirée de la sensibilité du dispositif Vinhall:

$$\eta_v = \frac{\Delta I_v}{I_v} \qquad \eta_v = \frac{\Delta I_v}{I_v} = 2,86 \times 10^2 \, (\frac{N_{D_s}}{N_i})^{\frac{1}{2}} \, BV_s \, (W_c + W_v) \, \frac{\varepsilon_s}{qD} \, (\frac{N_A}{N_A + N_{D_s}}) \tag{44}$$

L'équation (44) peut être ré-écrite de manière à décrire le cas particulier dans lequel l'implantation s'effectue de telle sorte que la concentration de surface $N_{D_s}$, des canaux Vinhall implantés soit égale à la concentration des accepteurs, $N_A$, dans le substrat, c'est-à-dire

$$N_{D_s} = N_A.$$

Dans ce cas particulier, l'équation (44) devient:

$$\eta_v = 1,43 \times 10^2 \, (\frac{N_A}{N_i})^{\frac{1}{2}} \, BV_s \, (W_c + W_v) \, \frac{\varepsilon_s}{qD} \tag{45}$$

Le signal différentiel de réponse du dispositif Vinhall de l'invention est obtenu en formant un produit de la forme $R_L \, \Delta I$. Ce produit est obtenu en multipliant le coefficient $\eta_v$ donné par l'équation (44) par $R_L$ (résistance de charge du dispositif) et par une expression appropriée du courant de canal, $I_c$, c'est-à-dire

$$\Delta E = R_L \, I_c \, \eta_v.$$

L'équation (46) ci-dessous définit le courant qui circule dans les canaux Vinhall et qui correspond au pincement:

$$I_{cp} = (Dq)^2 \, (\frac{W_v}{L}) \, \frac{\mu T}{2\varepsilon_s} \, \frac{N_A + N_{D_s}}{N_A} \tag{46}$$

En faisant le produit des équations (45) et (46) et de $R_L$, on obtient l'expression désirée de la tension du signal différentiel qui peut être mesurée entre les deux drains fonctionnant dans le mode de pincement, en supposant qu'un champ mangétique de densité B soit appliqué perpendiculairement au canal.

$$\Delta E = 1,43 \times 10^2 \, R_L \, (\frac{N_{D_s}}{N_i})^{\frac{1}{2}} \, Dq \, (\frac{W_v}{L}) \, \mu T \, BV_s \, (W_c + W_v) \tag{47}$$

17

Il ressort de l'équation (47) que le dispositif de l'invention peut fournir un signal d'une amplitude désirée quelconque, en supposant que des conditions de pincement existent, en donnant simplement à la résistance de charge $R_L$ une valeur importante. Toutefois, il est indispensable pour cela que la tension d'alimentation des drains, $V_{DD}$, augmente en fonction de la valeur choisie de $R_L$. Pour qu'un compromis raisonnable puisse être atteint, une valeur nominale de la résistance de charge, $R_{Lo}$, est définie de la façon suivante.

Le courant de pincement du canal ($I_p$ ou $I_{cp}$) peut être exprimé comme suit:

$$I_p = V_p \, [D \, (\frac{W_v}{L}) \, q\mu] \qquad (48)$$

où:

$V_p$ est la tension de pincement drain-source.

Si l'on exprime que la chute de tension en régime permanent, $I_p \, R_{Lo}$, aux bornes de la résistance de charge $R_{Lo}$, figure 13, et égale à tension de pincement dans le canal Vinhall, $V_p$, on obtient:

$$R_{Lo} \, V_p \, [D \, (\frac{W_v}{L}) \, q\mu] = V_p \qquad (49)$$

En extrayant $R_{Lo}$ de cette dernière équation, on obtient l'expression suivante de la résistance nominale de charge:

$$R_{Lo} = \frac{L}{W_v} \, (\frac{1}{Dq\mu}) \qquad (50)$$

Cette expression définit une valeur maximum de la résistance de charge $R_L$ telle que la tension d'alimentation des drains, $V_{DD}$, ne dépasse jamais le double de la valeur de la tension de pincement, $V_p$, du canal. Des signaux de sortie de plus grande amplitude peuvent être obtenus en augmentant la valeur de la résistance de charge, $R_L$, mais cela se traduit par une augmentation de la tension d'alimentation des drains (et par conséquent par une augmentation du bruit).

En remplaçant le terme $R_{Lo}$ dans l'équation (47) par sa valeur dans l'équation (50), on obtient une expression de la tension nominale du signal différentiel, $\Delta E_o$:

$$\Delta E_o = 1{,}43 \times 10^2 \, (\frac{N_{D_s}}{N_i})^{\frac{1}{2}} \times TBV_s \, (W_c + W_v) \qquad (51)$$

Dans le cas particulier déjà mentionné où la concentration de donneurs à la surface du canal implanté, $N_{D_s}$, est égale à la concentration des accepteurs dans le substrat, $N_A$, l'équation (51) devient:

$$\Delta E_o / N_{D_s} = 1{,}43 \times 10^2 \, (\frac{N_A}{N_i})^{\frac{1}{2}} \, TBV_s \, (W_c + W_v) \qquad (52)$$

Il ressort cependant de l'équation (51) que la tension nominale du signal augmente lorsque la concentration des donneurs à la surface du canal, $N_{D_s}$, est supérieure à la concentrations des accepteurs, $N_A$, tandis que, dans les mêmes conditions, la sensibilité du dispositif, $\eta_v$, équation (44), diminue. C'est en examinant les conditions requises pour obtenir du détecteur Vinhall des rapports signal/bruit importants que l'on pourra le mieux apprécier l'importance d'une faible résistivité du substrat, c'est-à-dire des valeurs importantes pour le terme $N_A$ et une valeur élevée correspondante pour la concentration à la surface, $N_{D_s}$.

On attend notamment d'un détecteur qu'il soit capable de lire de façon fiable des données codées enregistrées sur des bandes magnétiques. La densité maximum du flux qui existe à proximité immédiate d'une telle bande magnétique est d'environ 350 Gauss. La valeur minimum du champ à détecter peut ne pas dépasser 20 Gauss. La valeur de 350 Gauss est utilisée dans l'analyse ci-après pour déterminer le rapport signal/bruit maximum qui peut être obtenu en pratique du dispositif Vinhall.

Lors de la détermination du rapport signal/bruit, on étudiera les conditions qui définissent habituellement le bruit statistique. Il existe d'autres sources potentielles de bruit telles que le bruit d'injection et le bruit 1/f, ce dernier étant simulé par des processus de génération et de recombinaison et par des trajectoires courbes des électrons qui se produisent à proximité des drains. Ces autres types de source de bruit ne sont pas suffisamment bien comprises pour qu'on puisse les inclure dans l'analyse. Le bruit étudié ci-après est créé par des variations statistiques du courant qui circule dans le canal en traversant un élément de charge résistif.

La tension de bruit statistique qui existe aux bornes de la résistance de charge des drains, $R_L$, figure 1, est donnée par la relation (53):

$$V_{bruit} = R_L \ (2q \ I_c \ \Delta f)^{\frac{1}{2}} \qquad (53)$$

où:

$R_L$ est la valeur de la résistance de charge en ohms.
q est la charge des électrons
$I_c$ est le courant du canal Vinhall
$\Delta f$ est la largeur de bande utile de l'amplificateur du système de détection

Le rapport signal/bruit statistique est désigné $\beta$ et défini comme suit:

$$\beta = \frac{\Delta E}{V_{bruit}} = \frac{R_L \ \Delta I}{V_{bruit}} \qquad (54)$$

Compte tenu de la définition de la sensibilité, $\eta_v$, fournie par la relation (28), la relation (54) peut également s'écrire:

$$\beta = \eta_v \ (\frac{I_c}{2q \ \Delta f})^{1/2} \qquad (55)$$

On observera que le signal signal/bruit est indépendant de la résistance de charge, $R_L$. Il est donc permis d'ajuster cette résistance pour d'autres raisons.
Le terme:

$$(\frac{I_c}{2g \ \Delta f})^{1/2}$$

de la relation (55) peut être développé au moyen de la relation (46) qui correspond aux conditions de pincement du canal:

$$(\frac{I_{c \ p}}{2q \ \Delta f})^{1/2} = \frac{D}{2} \ (\frac{q}{\Delta f}) \ (\frac{W_v}{L}) \ \frac{\mu T}{\varepsilon_s} \ \frac{N_A + N_{D_S}}{N_A}^{1/2} \qquad (56)$$

Un expression du rapport signal/bruit basée sur la relation (55) peut être obtenue en simplifiant le produit des relations (56) et (44). Le résultat est donné par la relation (57) ci-dessous:

$$\beta = 1,43 \times 10^2 \ (\frac{N_A}{N_i} \ . \ \frac{N_{D_S}}{N_A + N_{D_S}})^{1/2} \ BV_s \ (W_c + W_v) \quad \times (\frac{\varepsilon_s}{q \Delta f} \ (\frac{W_v}{L}) \ \mu T)^{1/2} \qquad (57)$$

La relation (57) implique que le rapport signal/bruit maximum peut être obtenu si les concentrations des accepteurs, $N_A$, sont importantes (faible résistivité du substrat) et si la concentration des donneurs à la surface, $N_{D_S}$, pendant l'implantation est supérieure à $N_A$; c'est-à-dire si

$$N_{D_S} > N_A.$$

Ce dernier critère est en contradiction avec les conditions nécessaires pour obtenir une sensibilité, $\eta_v$, maximum, mais est nèan-moins considéré des plus importants du point de vue de l'obtention d'un détecteur optimum, rien ne pouvant être plus nuisible au bon fonctionnement du dispositif qu'un mauvais rapport signal/bruit. Un compromis sera donc nécessaire.
La figure est un graphique représentant le rapport signal/bruit, $\beta$, et une amplitude nominale du signal, $\Delta E_o$, prévus pour le détecteur Vinhall de l'invention, en fonction de la résistivité du substrat en ohm-cm. Un rapport signal/bruit de l'ordre de 60 db et une amplitude nominale du signal, $\Delta E_o$, voisine de 140 mv peuvent théoriquement être obtenus à partir d'un tel dispositif, pour un champ de 350 Gauss et une résistivité du substrat de 0,3 ohm-cm. Des rapports signal/bruit et des amplitudes de signal plus élevés peuvent être obtenus en augmentant la largeur du canal de couplage de telle sorte quelle soit supérieure à la valeur utilisée dans les calculs ci-dessus, que est de 0,007 mm, ou en diminuant la résistivité du substrat. Toutefois, des problèmes de claquage des drains peuvent éventuellement se produire si une résistivité du substrat inférieure à 0,02 ohm-cm est utilisée aux fins de la réalisation de détecteurs Vinhall.

On se reportera à présent aux figures 5 et 6 pour étudier brièvement des dispositifs à canal de conduction fonctionnant dans le mode d'enrichissement. La figure 3B représente une coupe longitudinale du dispositif représenté sur la figure 5 et qui comporte un substrat semi-conducteur 1 dans lequel on a réalisé par implantation ou par diffusion une source 5 et un ou plusieurs drains 6. La surface du substrat, particulièrement à proximité du canal 4, est recouverte d'une mince couche d'oxyde isolant 2, de façon classique, et d'une électrode de porte 7 en aluminium ou autre matériau conducteur déposé par évaporation ou par tout autre procédé approprié et à laquelle des tensions convenables peuvent être appliquées.

Ainsi que le comprendra l'homme de l'art, cela constitue un dispositif du type à transistor à effet de champ à canal de conduction dans lequel l'application de tensions appropriées à l'électrode de porte 7, à la source 5 et au(x) drain(s) 6 induit la formation d'un canal 4 de conduction de porteurs appelé également "couche d'inversion" entre la source et le ou les drains. Cela a pour effet de créer une densité effective de porteurs (équivalente à une dose) qui peut donc être définie en utilisant des termes analogues à ceux précédemment employés dans le cas d'un dispositif à canal implanté dans lequel les porteurs sont fournis par les ions implantés au-dessous de la surface du substrat. On peut démontrer que l'amplitude de la tension du signal de sortie du dispositif fonctionnant dans le mode d'enrichissement dans lequel les porteurs forment un canal de conduction est proportionnelle à la tension appliquée à l'électrode de porte et que le dispositif est moins sensible qu'un dispositif équivalent muni d'un canal enterré formé par implantation ionique (fonctionnant dans le mode d'appauvrissement). Cette perte de sensibilité est due au fait que l'épaisseur du canal T est faible et que la concentration correspondante des donneurs dans le canal, $N_D$, est importante. Ce dernier facteur diminue l'importance de la modulation des régions d'appauvrissement qui peut être obtenue le long du canal pour un champ de Lorentz donné.

Les équations ci-dessus montrent que la performance d'un détecteur Vinhall sont notamment fonction de la densité (ou dose) des porteurs, puisque comme on l'a vu les dispositifs Vinhall fonctionnant dans le mode d'enrichissement ne présentent pas de porteurs fournis par des ions implantés, mais possèdent une densité équivalente dans la couche de charge créée par effet d'inversion par l'électrode de porte combinée à la mince couche d'oxyde qui sépare l'électrode de porte de la surface du substrat en silicium. En supposant que la concentration $N_D$ des porteurs formés par inversion à la surface du canal soit uniforme dans une couche d'épaisseur T égale à environ 1000 Å, une densité induite équivalente $\overline{D}$ peut être déterminée en étudiant les limites des régions d'appauvrissement pour le champ diélectrique existant à la surface du semi-conducteur par suite de l'action de la tension de porte au travers de la mince couche d'oxyde en direction du substrat en silicium. La relation existant entre la densité effective $\overline{D}$ et la tension de porte $V_g$ est donnée par l'expression (58) ci-dessous:

$$\overline{D} = \frac{V_g C_o}{2q} \tag{58}$$

où $C_o$ est la capacité de la porte par cm² qui est donc égale à la constante diélectrique $\varepsilon$ divisée par l'épaisseur de la couche d'oxyde, $t_{ox}$.

En utilisant l'expression ci-dessus afférente à $\overline{D}$ dans les équations précédemment données relatives aux dispositifs Vinhall fonctionnant dans le mode d'appauvrissement, on peut obtenir l'expression équivalente pour les dispositifs fonctionnant dans le mode d'enrichissement. Il est en effet important de noter que le fonctionnement des dispositifs Vinhall suit un mécanisme identique, que ces dispositifs fonctionnement dans le mode d'enrichissement ou dans le mode d'appauvrissement.

On a représenté sur la figure 18 une coupe longitudinale d'un substrat semi-conducteur 1 dans lequel est enterré un canal 4. Ce dispositif présente les caractéristiques suivantes:

Le canal 4 est créé en implantant du phosphore, par exemple, de telle sorte qu'une concentration profonde et uniforme des porteurs soit obtenue au-dessous de la surface du substrat sur une profondeur d'environ 4000 Å ou davantage. Une dose typique souhaitable d'implantation est d'environ $2 \times 10^{12}$ ions/cm². Il est particulièrement souhaitable que cette dose soit implantée en utilisant une énergie comprise entre 50 et 200 KeV.

Un canal profond dont l'épaisseur T est de l'ordre de 4000 Å, est donc produit en commençant à 500 Å environ au-dessous de la surface du substrat. Un tel canal est souhaitable pour obtenir le courant de canal nécessaire tout en permettant une modulation importante des régions d'appauvrissement le long des côtés du canal. Ainsi qu'on l'a précédemment observé, lors de la détermination des équations, il est également important que le canal soit enterré à une profondeur importante au-dessous de la surface du substrat semi-conducteur de manière à réduire le bruit et à permettre l'obtention d'un meilleur rapport signal/bruit. L'électrode de porte 7 fait en tout état de cause fonction d'écran électrique de manière à diminuer le bruit, mais n'est pas réellement nécessaire pour commander la conduction du canal.

**0 005 183**

Dans ces conditions la figure 19 représente une variante de la réalisation de la figure 11 dans laquelle l'électrode de porte 7 a été complètement supprimée et dans laquelle la surface supérieure est recouverte d'un isolant opaque 16. L'objet de ce dernier est d'empêcher la lumière de pénétrer dans le substrat semi-conducteur et de provoquer du bruit par suite de l'injection d'électrons dans le canal, qui serait provoquée par l'action des photons.

La région la plus sensible du dispositif Vinhall se trouve à proximité des drains et est la seule région qui exige la présence d'un champ magnétique pour moduler les régions d'appauvrissement référencées $S_B$ sur la figure 10. Cette caractéristique du dispositif Vinhall explique non seulement sa résolution élevée, mais aussi sa grande sensibilité. Le détecteur Vinhall fait donc essentiellement fonction de détecteur pontuel.

Si le dispositif Vinhall fonctionne au-dessous de la tension de pincement (voir figure 14), il est souhaitable que la largeur $W_D$ des drains 6 représentés sur la figure 7 soit égale ou inférieure à la largeur $W_S$ de la région 8 qui les sépare. Si tel n'est par le cas, la conductance entre les drains 6 atténuera de façon excessive le signal différentiel mesuré entre les drains.

Il est souhaitable qu'une région 8 de faible largeur existe entre les drains 6 afin que le dispositif Vinhall présente une sensibilité optimum. Des techniques spéciales de fabrication peuvent être employées pour réduire la distance séparant les drains. L'une de ces techniques consiste à implanter les deux drains 6 aussi près que possible l'un de l'autre que le permettent les techniques de masquage photolithographiques, puis à procéder à une opération d'étalement classique (drive in) permettant une migration limitée des ions à une température critique de recuit proche de la température de diffusion. Cette température est d'environ 1000°C dans le cas du silicium et varie en fonction des matériaux employés. On peut ainsi obtenir un espacement fixe dont la largeur est inférieure à la largeur minimum que permettent d'obtenir les techniques photolithographiques.

Une autre technique consiste à implanter une région de drain d'un seul tenant dans laquelle on pratique ensuite une ouverture de masquage très fine au moyen d'un faisceau électronique. Des ions d'un matériau de type opposé à celui du drain sont implantés de manière à créer une séparation électrique entre les deux parties du drain. Ledit matériau implanté forme une zone qui neutralise l'implantation initialement effectuée dans cette région. De la sorte, la région de l'espacement peut être rendue de type intrinsèque ou de même type que le matériau constituant le canal. Les deux drains ainsi formés sont fortement dopés de manière à éviter leur appauvrissement lorsqu'une tension élevée leur est appliquée.

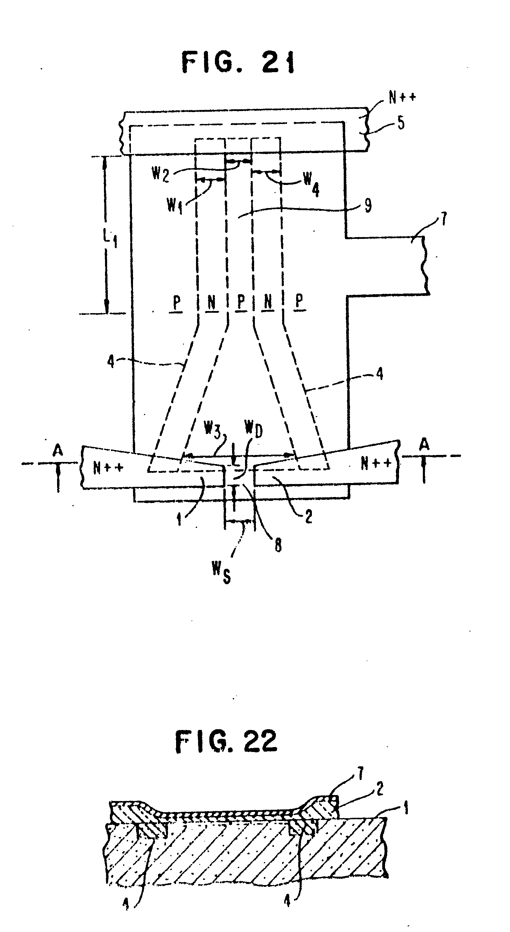

D'autres réalisations permettant d'obtenir un meilleur fonctionnement sont représentées sur les figures 21, 22, 23 et 24.

On a représenté sur la figure 21 une vue de dessus d'un détecteur Vinhall perfectionné à deux canaux de conduction séparés par un canal de couplage. Ce dispositif se distingue de ceux précédemment décrits par le fait que le canal de couplage est évasé à proximité des drains 6. A une certaine distance $L_1$ mesurée depuis la source 5, les canaux Vinhall 4 cessent d'être parallèles et s'écartent l'un de l'autre, tout en conservant la même largeur, ce qui a pour effet d'augmenter la largeur du canal de couplage 9. A cela prêt, le dispositif est du même type que celui précédemment décrit à propos des figures 7 et 8 et que d'autres dispositifs analogues ici décrits. Dans le dispositif de la figure 21, les canaux Vinhall 4 sont formés au moyen d'une technique d'implantation ionique précédemment décrite. Ils ont la forme d'un filament ou d'une bande étroite et sont réalisés de telle sorte que le volume de la région d'appauvrissement qui les entoure représente une partie importante de celui de chaque canal. De ce fait, la modulation des dimensions des régions d'appauvrissement par la tension de Lorentz modifie une partie aussi importante du canal que possible. Le dispositif de la figure 21 présente des caractéristiques très différentes de celles des dispositifs précédemment mentionnés.

La différence principale réside dans le fait que le canal de couplage évasé présente une concentration de porteurs (résultant d'une implantation ou d'un effet d'inversion) nettement plus faible que celle des canaux Vinhall 4. Une seconde différence importante réside dans le fait que c'est la partie étroite du canal évasé 9 (c'est-à-dire la partie de celui-ci qui est proche de la source 5), qui détermine essentiellement, par sa largeur et par sa profondeur, l'intensité totale du courant de Lorentz d'une façon qui est pratiquement indépendante de ce qui se passe dans la partie évasée du canal 9 (à proximité des drains (6). L'evasement du canal de couplage permet de réduire l'intensité de la composante du courant de Lorentz qui apparaît aux drains 6 et d'augmenter la tension de Lorentz qui peut être obtenue en fonction du courant disponible pour moduler les dimensions des régions d'appauvrissement entourant les canaux Vinhall 4 à proximité des drains. Une troisième différence importante réside dans le fait que c'est la largeur, désignée $W_3$ sur les figures, du canal de couplage 9 qui détermine l'importance de la modulation des régions d'appauvrissement des canaux Vinhall 4, et que c'est la largeur $W_2$ de ce même canal 9 qui commande le courant de Lorentz, compte tenu de la dose efficace implantée ou induite dans ce canal.

Le courant total circulant dans le canal de couplage 9 est réparti entre les drains 6 et ne constitue qu'une faible partie du courant circulant dans l'un ou l'autre des canaux Vinhall 4. Le canal de couplage évasé 9 a la même fonction que les canaux de couplage non évasés précédemment décrits, mais présente les amélioration indiquées plus haut. L'emploi de dispositifs de ce type permet d'obtenir une nette amélioration de la sensibilité et des rapports signal/bruit.

21

La figure 22 représente une coupe, prise suivant la ligne A—A, du dispositif de la figure 21. La figure 22 montre que le dispositif représenté fonctionne dans le mode d'enrichissement, c'est-à-dire dans lequel une couche d'inversion destinée à permettre la conduction des porteurs est créée par l'application d'une tension à la couche métallique 7 faisant fonction d'électrode de porte. Cette dernière est séparée de la surface du substrat semi-conducteur 1 par une mince couche de dioxyde de silicium 2. La porte métallique 7 recouvre les canaux de Vinhall 4 ainsi que le canal de couplage 9. Cela est nécessaire pour obtenir un bon couplage électrique entre les canaux 9 et 4.

Les largeurs $W_1$ et $W_4$ des canaux Vinhall 4 de la figure 21 sont essentiellement les mêmes que celles décrites à propos de la figure 7, par exemple. Ces canaux 4 ont la forme d'un filament, mais peuvent aussi être évasés au voisinage des drains 6, de la même façon que le canal de couplage 9 sur la figure 21.

Cette dernière possibilité est illustrée par les figures 23 et 24 dans le cas d'un détecteur Vinhall à deux canaux de conduction fonctionnant dans le mode d'appauvrissement.

Le dispositif représenté sur la figure 23 est analogue à celui de la figure 21, mais les canaux de Vinhall 4 sont à leur tour évasés au voisinage des drains 6. De même que dans le cas des figures 21 et 22, l'espacement 8 et les largeurs des canaux 4 et 9 à proximité de la source ($W_1$, $W_2$ et $W_4$) sont essentiellement les mêmes que dans le cas des réalisations précédemment décrites.

Sur la figure 23, les deux canaux 4 et le canal de couplage 9 sont tous trois évasés en direction des drains 6. Cela permet d'obtenir une amélioration supplémentaire de la performance pour des raisons qui sont essentiellement les mêmes que celles précédemment mentionnées à propos du dispositif de la figure 21 dans lequel seul le canal de couplage 9 était évasé.

Sur la figure 24, qui représente une coupe du dispositif de la figure 23, prise suivant la ligne A—A, on peut voir que le dispositif est destiné à fonctionner dans le mode d'appauvrissement; en effet le canal de couplage 9 est réalisé par implantation lors de la formation, par implantation également, des canaux Vinhall 4 et des drains 6. Toutefois, la dose d'implantation dans le canal 9 est beaucoup plus faible que celle employée aux fins des canaux 4 ou des drains 6. La couche d'oxyde 2 présente une épaisseur moindre dans la région qui se trouve au-dessus des canaux évasés 4 et 9, mais cela n'est pas indispensable étant donné que le fonctionnement du dispositif ne dépend pas d'un canal induit formé par l'effet d'inversion.

Il est évident que, dans le cas des dispositifs représentés sur les figures 21 et 23, la distance $L_1$ au-delà de laquelle l'évasement du ou des canaux commence est une affaire de choix. Cet évasement peut en effet commencer au niveau de la source en direction des drains, ou commencer à une distance supérieure à $L_1$. Pour les raisons précédemment données, en vertu desquelles c'est la largeur des canaux qui commande le courant ultérieurement obtenu en aval, en direction des drains, il est particulièrement souhaitable que l'évasement commence au-delà d'une distance $L_1$ qui peut être comprise entre au moins 1/10ième et environ la moitié ou davantage de la longueur totale du canal, cette distance étant mesurée depuis la source en direction des drains.

Il est intéressant de comparer à présent un détecteur vinhall dont les conducteurs ont la forme d'un filament avec certains dispositifs de l'art antérieur.

Cette forme d'un canal conducteur est définie par le rapport de la largeur Vinhall $W_v$ à la largeur totale du canal, W. La relation (20) sera le point de départ de cette analyse. Dans la relation (20), la largeur de la région d'appauvrissement à l'intérieur d'un canal sur l'un des côtes de celui-ci, est décrite en fonction de plusieurs variables. Les valeurs optimum de ces dernières sont supposées être les suivantes:

$\varepsilon_S = 1,04 \times 10^{-12}$
$q = 1,6 \times 10^{-19}$
$N_A = N_D = 10^{17}$
$\phi = 4 \times 10^{-1}$ (selon la définition donnée à propos de la relation (19)).

Avec ces hypothèses, la largeur de la région d'appauvrissement $1_n$ à proximité de la source d'un dispositif Vinhall (le terme V de la relation (20) étant nul) est d'approximativement 510 Å. La largeur totale de la région d'appauvrissement est égale à deux fois cette valeur, soit 1000 Å environ, et dans le cas le plus défavorable, c'est-à-dire celui d'un dispositif Vinhall à canal large, avec une largeur de canal W de 50 000 Å, le rapport $W_v/W$ est égal à 0,98. Si l'on choisit comme largeur totale du canal une valeur plus appropriée, à savoir 25 0000 Å, ce rapport devient 0,96.

On remarquera que, dans ce qui précède, on s'est placé dans le cas le plus défavorable en ce qui concerne le paramètre de Vinhall" et dans le cas le plus favorable en ce qui concerne les largeurs des régions d'appauvrissement. Une comparaison avec certains dispositifs connus de l'art antérieur, pris dans leurs conditions les plus favorables, donne les résultats suivants:

Dans le cas d'un dispositif Hall typique présentant les dimensions les plus réduits ($6,25 \times 10^{-4}$ mm²), le rapport de la largeur Vinhall à la largeur du canal à proximité de la source est égal à 0,999 environ. Elargir ou allonger le dispositif Hall n'aura d'autre effet que d'approcher le rapport de 1,0 étant donné que la largeur de la région d'appauvrissement telle qu'elle est définie par la relation (20) n'est pas fonction de la largeur du canal.

# 0 005 183

Dans le cas du dispositif de l'art antérieur décrit dans la publication précitée intitulée "IBM Technical Disclosure Bulletin", Vol. 13, No. 12, mai 1971, page 3633, et compte tenu des dimensions physiques les meilleures dans lesquelles il pourrait être réalisé, on obtient un rapport de la largeur de Vinhall à la largeur du canal à proximité de la source, qui est effectivement proche de l'unité.

Une application de l'invention réside dans les lecteurs de bandes magnétiques.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

## Revendications

1. Détecteur de champ du type transistor à effet de champ à semi-conducteur, comportant un substrat en matériau semi-conducteur, une région de source et au moins deux régions de drain distinctes, caractérisé en ce qu'il comprend: au moins deux canaux de conduction formés dans le substrat qui connectent chacun lasite source et un drain, ces canaux ayant la forme d'un filament défini par le fait que le rapport de la largeur Vinhall à la largeur du canal à proximité de ladite source est supérieur à 0 et inférieur à 0,98, et un canal de conduction engendrant une tension de Lorentz, disposé dans ledit substrat entre les canaux, couplant électriquement ces derniers, de telle sorte que la tension de Lorentz leur soit appliquée dans une direction perpendiculaire au parcours des porteurs dans les canaux.

2. Détecteur selon la revendication 1, caractérisé en ce qu'il comprend également: une résistance de charge distincte connectée à chacun des drains en série avec une source de tension, et en ce que la distance séparant la source et les drains divisée par ladite largeur Vinhall est supérieure à la valeur définie par la résistance de charge multipliée par la densité par la mobilité des porteurs dans le canal et la charge unitaire des électrons dans lesdits premiers canaux.

3. Détecteur selon la revendication 1 ou 2, caractérisé en ce que: le rapport de la largeur Vinhall de chacun des deux premiers canaux à proximité des drains à la largeur Vinhall de chacun des canaux au niveau de ladite source est supérieur á 1.

4. Détecteur selon la revendication 1, caractérisé en outre en ce que: le rapport de la largeur Vinhall de chacun des deux premiers canaux en un point intermédiaire situé entre la source et les drains à la largeur Vinhall de chacun desdits canaux au niveau de drains est supérieur à 1, et en ce que le rapport de ladite largeur au niveau dudit point intermédiaire à la largeur Vinhall au niveau de ladite source est égal à 1

5. Détecteur selon l'une quelconque des revendications 1 à 4, caractérisé en outre en ce que: la distance séparant les drains est inférieure à la largeur Vinhall.

6. Détecteur selon l'une quelconque des revendications 1 à 5, caractérisé en outre en ce que: les deux premiers canaux se trouvent au-dessous de la surface du substrat et sont séparés de celle-ci par une couche d'un matériau de type de conductivité opposé à celui desdits canaux, et de la surface dudit substrat par une distance inférieure à la largeur Vinhall.

7. Détecteur selon l'une quelconque des revendications 1 à 6, caractérisé en outre en ce que: la largeur Vinhall de chacun des deux premiers canaux est supérieure á l'épaisseur de ces derniers prise perpendiculairement à la surface du substrat.

8. Détecteur selon l'une quelconque des revendications 1 à 7, caractérisé en ce qu'il comprend en outre: des moyens permettant d'appliquer entre la source et les drains une tension d'amplitude suffisante pour créer un pincement des deux premiers canaux à proximité desdits drains.

9. Détecteur selon l'une quelconque des revendications 1 à 8, caractérisé en outre en ce que: le rapport de la largeur dudit canal conducteur engendrant une tension de Lorentz à proximité des drains, à la largeur dudit canal au niveau de ladite source est supérieur à un.

10. Détecteur selon l'une quelconque des revendications 1 à 8, caractérisé en outre en ce que: le rapport de la largeur dudit canal de couplage engendrant une tension de Lorentz en un point intermédiaire de celui-ci situé entre la source et les drains, à la largeur du canal au niveau de ladite source est égal à un, et en ce que le rapport de ladite largeur dudit canal audit point intermédiaire à la largeur dudit canal à proximité desdits drains est inférieur à un.

## Patentansprüche

1. Feld-Meßfühler vom Feldeffekttransistortyp, bestehend aus einem Halbleitersubstrat, einer Sourcezone und wenigstens zwei voneinander abgesetzten Drainzonen, gekennzeichnet durch: wenigstens zwei im Substrat gebildete Kanäle, von denen jeder die Sourcezone mit einer Drainzone verbindet, wobei fadenförmig ausgebildete Kanäle dadurch definiert sind, daß das Verhältnis der Vinhall-Breite zur Kanalbreite in der Nähe der Sourcezone größer als 0 und kleiner als 0,98 ist, und einen eine Lorentzspannung hervorrufenden Kanal, der im Substrat zwischen besagten Kanälen liegt, indem diese hierdurch in der Weise elektrisch gekoppelt werden, daß ihnen die Lorentzspannung senkrecht zur Ladungsträger-Flußrichtung in den Kanälen angelegt wird.

2. Meßfühler nach Anspruch 1, dadurch gekennzeichnet, daß weiterhin eingeschlossen ist: ein besonderer, jeweils an den Drainzonen in Serie mit einer Spannungsquelle angeschlossener Lastwiderstand, und dadurch, daß der die Sourcezone von den Drainzonen trennende Abstand geteilt durch die besagte Vinhall-Breite größer ist als der Wert, der definiert ist durch Lastwiderstand multipliziert mit Ladungsträger-Dichte und Beweglichkeit im Kanal sowie mit Elektronen-Einheitsladung in besagten ersten Kanälen.

3. Meßfühler nach Anspruch 1 oder 2, dadurch gekennzeichnet, daß das Verhältnis der jeweiligen Vinhall-Breite der beiden ersten Kanäle in der Nähe der Drainzonen zur jeweiligen Vinhall-Breite der Kanäle im Bereich besagter Sourcezone größer als 1 ist.

4. Meßfühler nach Anspruch 1, weiterhin dadurch gekennzeichnet, daß das Verhältnis der jeweiligen Vinhall-Breite der beiden ersten Kanäle an einem zwischen der Sourcezone und den Drainzonen gelegenen Punkt zur jeweiligen Vinhall-Breite besagter Kanäle im Bereich der Drainzonen größer als 1 ist, und dadurch, daß das Verhältnis besagter Breite im Bereich besagten Zwischenpunktes zur Vinhall-Breite im Bereich der Sourcezone gleich 1 ist.

5. Meßfühler nach einem der Ansprüche 1 bis 4, darüber hinaus dadurch gekennzeichnet, daß der die Drainzonen trennende Abstand kleiner als die Vinhall-Breite ist.

6. Meßfühler nach einem der Ansprüche 1 bis 5, weiterhin dadurch gekennzeichnet, daß sich die beiden ersten Kanäle unterhalb der Substratoberfläche befinden und hiervon durch eine Schicht eines Materials, das vom den Kanälen entgegengesetzten Leitungstyp ist, und von der Oberfläche besagten Substrats durch einen Abstand getrennt sind, der kleiner als die Vinhall-Breite ist.

7. Meßfühler nach einem der Ansprüche 1 bis 6, weiterhin dadurch gekennzeichnet, daß die jeweilige Vinhall-Breite der beiden ersten Kanäle größer als deren Dicke, senkrecht zur Oberfläche des Substrats gesehen, ist.

8. Meßfühler nach einem der Ansprüche 1 bis 7, weiterhin gekennzeichnet durch: Maßnahmen zum Anlegen einer Spannung zwischen Source- und Drainzonen mit derart großer Amplitude, daß ein Einschnüren der beiden ersten Kanäle in der Nähe besagter Drainzonen herbeigeführt wird.

9. Meßfühler nach einem der Ansprüche 1 bis 8, weiterhin gekennzeichnet durch: das Verhältnis der Breite des besagten Kanals mit in der Nähe der Drainzonen hervorgerufener Lorentzspannung zur Breite des Kanals im Bereich der Sourcezone größer als 1.

10. Meßfühler nach einem der Ansprüche 1 bis 8, weiterhin dadurch gekennzeichnet, daß das Verhältnis der Breite des besagten Koppelkanals, mit an einem Zwischenpunkt zwischen Sourcezone und Drainzonen hervorgerufener Lorentzspannung zur Breite des Kanals im Bereich der Sourcezone gleich 1 ist, und dadurch, daß das Verhältnis der Breite des Kanals an diesem Zwischenpunkt zur Breite des Kanals in der Nähe der Drainzonen kleiner als 1 ist.

## Claims

1. Field sensor of the semiconductive field effect transistor type comprising a substrate of semiconductive material, a source region, and at least two separate drain regions, characterized in that it includes: at least two conductive channels in said substrate, each one connecting said source and one drain, said channels having a filamentary form defined by a Vinhall width to channel width ratio in the vicinity of said source that is greater than 0 and less than 0.98, and a Lorentz voltage generating conductive channel in said substrate between the channels, electrically coupling these together so as to apply a Lorentz voltage thereto in a direction perpendicular to the carrier flow in the channels.

2. Field sensor according to claim 1, characterized in that it also comprises: a separate load resistance connected to each of the drains in series with a voltage source, and in that the distance between the source and the drains divided by said Vinhall width is greater than the value defined by the load resistance multiplied by the channel carrier density, by the channel carrier mobility and by the electron unit charge in the first channels.

3. Field sensor according to claim 1 or 2, characterized in that: the ratio of the Vinhall width of each of the two first channels in the vicinity of the drains to the Vinhall width of each of the channels at the level of said source is greater than 1.

4. Field sensor according to claim 1, further characterized in that the ratio of the Vinhall width of each of the two first channels at an intermediate point between the source and the drains to the Vinhall width of each of said channels at the drain level is greater than 1, and the ratio of said width at the level of said intermediate point to the Vinhall width at the level of said source is equal to 1.

5. Field sensor according to any one of claims 1 to 4, further characterized in that: the distance separating the drains is less than the Vinhall width.

6. Field sensor according to any one of claims 1 to 5, further characterized in that: the two first channels are lying beneath the substrate surface and separated therefrom by a layer of material of opposite conductivity to said channels and from the surface of said substrate by a distance which is less than the Vinhall width.

7. Field sensor according to any one of claims 1 to 7, further characterized in that: the Vinhall width of each of the two first channels is greater than the thickness thereof in the direction perpendicular to the surface of the substrate.

24

8. Field sensor according to any one of claims 1 to 7, further characterized in that it comprises: means for applying between the source and the drains a voltage of sufficient amplitude to create pinch off of the two first channels in the vicinity of said drains.

9. Field sensor according to any one of claims 1 to 8, further characterized in that: the ratio of the width of said conductive channel generating a Lorentz voltage in the vicinity of the drains to the width of said channel at the level of said source is greater than 1.

10. Field sensor according to any one of claims 1 to 8, further characterized in that: the ratio of the width of said coupling channel generating a Lorentz voltage at an intermediate point between the source and the drains to the width of the channel at the level of the source is equal to 1, and the ratio of said width of said channel at said intermediary point in the vicinity of said drains is less than 1.

FIG. 1

FIG. 5

FIG. 14

FIG. 2

FIG. 3

FIG. 4

# FIG. 7

# FIG. 8

# FIG. 9

B = 0

$W_V$    4    9    $W_V$    4

T    $A_1$    $A_2$    1

P

$W_C$

# FIG. 10    B ≠ 0

$W_{n_L}$    $S_L$

$S_L$    $W_{n_L}$

$W_{n_B}$    $W_{n_B}$

$S_B$    13    $S_B$

# FIG. 20

10000

1000

$\beta$ = RAPPORT SIGNAL/BRUIT

100

$\Delta E_0$

SIGNAL DE SORTIE POUR
350 GAUSS

1,0    10,0    $\delta$ ohm-cm

RESISTIVE DU SUBSTRAT

4

CONCENTRATION DES DONNEURS

# FIG. 12

$N_{Dp}$

$\bar{N}_D$

$N_{DS}$

CONCENTRATION DES ACCEPTEURS DANS LE SUBSTRAT

$Z$

PROFONDEUR DU CANAL

# FIG. 13

$R_L$

$V_{DD}$

$I_{P_1}$

$I_{P_2}$

$V_P$

$V_P$

# FIG. 6

2   4   N   7

N+

P

N+

5

6

1

JONCTION
METALLURGIQUE

SUBSTRAT

FIG. 15

$q^{N_D}$

CANAL
N

$\ell_P$

$\ell_n$

$q^{N_A}$

$\ell$

FIG. 16

$E_0$

FIG. 17

$\phi - V$

# FIG. 18

# FIG. 19

# FIG. 11

# FIG. 21

# FIG. 22

# FIG. 23

# FIG. 24